# EUROPEAN PATENT APPLICATION

(11) **EP 2 537 875 A1**
(43) Date of publication of application: **26.12.2012**
(21) Application number: 11744616.1
(22) Date of filing: 15.02.2011
(51) Int. Cl.: C08G 73/00, C09B 55/00

(54) **NOVEL POLYAZOMETHINE**

(30) Priority: 18.02.2010 JP 2010033561
(71) Applicant: Soken Chemical & Engineering Co., Ltd., Toshima-ku Tokyo 171-8531 (JP)
(72) Inventor: OKAMOTO, Syuji, Sayama-shi Saitama 350-1320 (JP); MEGURO, Hikaru, Sayama-shi Saitama 350-1320 (JP)
(74) Representative: Gulde Hengelhaupt Ziebig & Schneider
(86) International application number: PCT/JP2011/053103
(87) International publication number: WO 2011/102330

(57) **Abstract**

An object of the present invention is to provide a novel polyazomethine which is soluble in relatively versatile organic solvents including hydrophobic solvents such as toluene, alcohol solvents such as methanol and ethanol, glycol solvents such as propylene glycol monomethyl ether, and ester solvents such as methyl lactate, while securing carrier mobility sufficient for a semiconductor material. The polyazomethine of the present invention is characterized by including a repeating unit that contains a divalent aromatic ring-containing conjugated group wherein an azomethine group and a divalent aromatic group which may have a substituent are alternately bonded and conjugated and a divalent hydrocarbon group which may have a group that is not conjugated with the azomethine group and has an oxygen atom, a sulfur atom or a cycloalkylene group, with the aromatic ring-containing conjugated group and the hydrocarbon group being bonded with each other via the azomethine group.

## Description

### TECHNICAL FIELD

The present invention relates to a novel polyazomethine.

### BACKGROUND ART

With respect to the application of a polyazomethine having a conjugated structure developed into a straight chain shape, various applications have been studied, which include organic semiconductor materials for electronic and optical device materials, for use in LED's, thin-film transistors, solar batteries, etc.

In general, a conventional polyazomethine has a conjugated-type polymer structure in which an aromatic ring, a hetero ring, or an aromatic ring and an hetero ring are included in its main chain are bonded with one another via an azomethine group, to form a plurality of aromatic rings and/or hetero rings that are connected to one after another.

In the case when the polyazomethine is utilized as an organic semiconductor material, upon forming the semiconductor layer on a substrate, a method in which the polyazomethine is dissolved in a solvent and the resulting solution is applied onto the substrate is convenient and low-cost. However, the polyazomethine is a conjugated type material as described above, and is a compound having a rigid structure with high planarity, with the result that it is inferior in solubility to an organic solvent. For this reason, it is impossible to dissolve the polyazomethine in an organic solvent and to apply the resulting solution onto a substrate.

For this reason, a method has been proposed in which polyazomethine is polymerized while a monomer is vacuum-vapor deposited on a target substrate so that a semiconductor layer is formed (see Patent literature 1); however it cannot be said that this method is a desirable method because of complicated processes and a low yield of polyazomethine.

Moreover, with respect to the solvent solubility of polyazomethine disclosed in Patent literature 1, it has been known that in a protic acid such as m-cresol or in an organic solvent containing the acid, the polyazomethine forms a reversible Lewis acid-base pair and in this state, the polyazomethine is allowed to exert a solubility to the solvent (see Non-Patent literatures 1 to 4).

However, it cannot be said that this protic acid or organic solvent containing a protic acid has versatility. Moreover, since the organic solvent is corrosive, the polyazomethine solution prepared by dissolving the polyazomethine in this solvent is limited in its industrial use.

Moreover, Patent literature 2 has disclosed an invention relating to an organic LED element containing polyazomethine, and its polyazomethine is represented by the following formula (I).

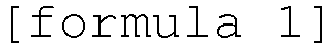

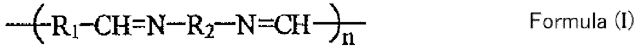

where R1 and R2 are any one of the member selected from the group consisting of: 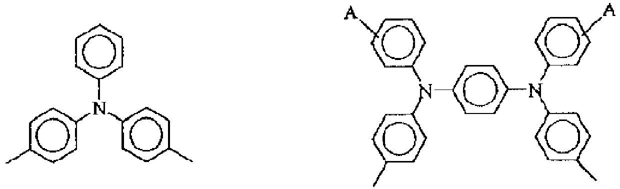 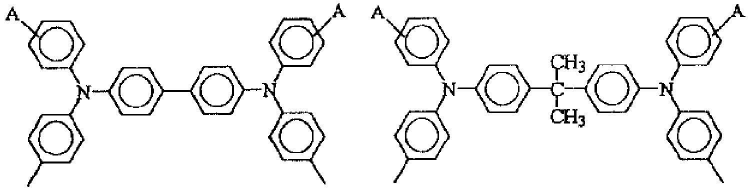 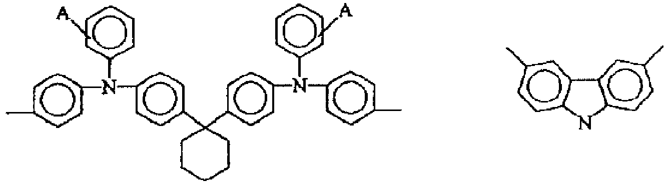 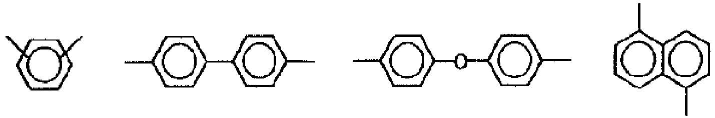 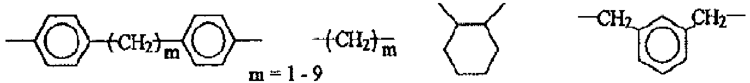 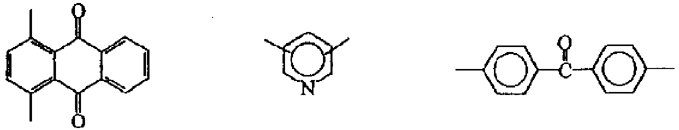 and -A is any one of the members selected from the group consisting of:

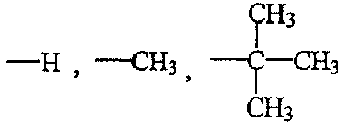

The members of the group to be selected include not only an aromatic ring conjugated structure, but also a non-conjugated structure, such as a -(CH₂)ₘ- group and a cyclohexylene group.

Moreover, Patent literature 2 has disclosed in [0013] that such polyazomethine is polymerized in m-cresol or benzene, and the resultant polyazomethine solution is formed as a film onto a substrate (anode) by using a wet film-forming method such as a spin-coating method, a dip-coating method, and then heated in an inert gas atmosphere so that a polyazomethine layer is formed thereon.

In Patent literature 2, however, no description has been given as to whether or not the polyazomethine represented by the above-mentioned formula (I) was actually synthesized. Moreover, m-cresol and benzene to which the polyazomethine of Patent literature 2 is supposed to be dissolved cannot be said as a versatile material. Furthermore, m-cresol is corrosive as described above and benzene is a cancer-inducing material so that both of the two materials are harmful to the human body.

For these reasons, the polyazomethine solution prepared by dissolving the polyazomethine in m-cresol or benzene of Patent literature 2 is limited in its industrial application. Moreover, neither description nor implication has been given in Patent literature 2 as to whether or not the polyazomethine can be dissolved in another solvent (for example, alcohol) that is highly versatile.

On the other hand, with respect to polyazomethine having such a low solubility to an organic solvent, it has been reported that by introducing an alkyl group, an alkoxy group, or the like to an aromatic ring, a hetero ring, or an aromatic ring and a hetero ring in its main chain, the polyazomethine is allowed to exert solubility to a single solvent, such as chloroform, THF, DMF, DMSO, NMP, m-cresol (see Non-Patent literature 5).

However, since such a material monomer in which an alkyl group or an alkoxy group is introduced to such aromatic ring and/or a hetero ring is not available commercially so that it is considered that the industrialization of the polyazomethine is difficult. Moreover, solvent species to be used sometimes have a halogen-containing structure, and in such a case, the solvent specie has a high boiling point. Consequently, because of a difficult health care administration for handlers and a high energy requirement for a drying process for the solvent, the industrial application of the solvent is not considered to be desirable. Moreover, from the viewpoint of chemical structure, the introduction of a substituent into such a conjugated system causes degradation of planarity in its original conjugated system due to a steric hindrance possessed by its compound, and subsequent degradation of crystallinity inside the polyazomethine molecule and among the molecules as well as deterioration in carrier mobility required for the organic semiconductor material. However, as can be seen in a hexyl group of poly(3-hexylthiophene)(P3HT) having high stereoregularity, in the case when the substituent is an alkyl group or the like having an effect for inducing the crystallinity inside the conjugated molecules, this problem can be avoidable.

### CITATION LIST

### PATENT LITERATURE

Patent Literature 1: JP-A-8-113622
Patent Literature 2: JP-A-9-194832

### NON-PATENT LITERATURE

Non-Patent Literature 1: Chem. Mater. 1991, 3, 878
Non-Patent Literature 2: Chem. Mater. 1994, 6, 196
Non-Patent Literature 3: Chem. Mater. 1995, 7, 1276
Non-Patent Literature 4: Macromolecules 1995, 28, 1180
Non-Patent Literature 5: Macromolecules, vol. 38, No. 5, p1958-1966, 2005

### SUMMARY OF THE INVENTION

### TECHNICAL PROBLEM

In view of these problems, the objective of the present invention is to provide a novel polyazomethine which is soluble in relatively versatile organic solvents including hydrophobic solvents such as toluene, alcohol solvents such as methanol and ethanol, glycol solvents such as propylene glycol monomethyl ether, and ester solvents such as methyl lactate, while securing carrier mobility sufficient for a semiconductor material.

### SOLUTION TO PROBLEM

The polyazomethine of the present invention is characterized by including a repeating unit that contains a divalent aromatic ring-containing conjugated group in which an azomethine group and a divalent aromatic group that may have a substituent are alternately bonded and conjugated and a divalent hydrocarbon group which may have a group that is not conjugated with the azomethine group and may have an oxygen atom, a sulfur atom or a cycloalkylene group, and in this structure, the aromatic ring-containing conjugated group and the hydrocarbon group are bonded with each other via the azomethine group.

In the conventional polyazomethine, the polyazomethine has an aromatic ring, a hetero ring, or a aromatic ring and hetero ring, and these are bonded to one another by an azo methine group so that a conjugated polymer structure in which a plurality of aromatic rings and/or hetero rings are bonded to one another is formed. This is because a carrier is transferred within one molecule of polyazomethine. This conjugated polymer structure causes a low solubility of polyazomethine to an organic solvent. In order to increase the solubility, a method is proposed in which an alkyl group or a alkoxy group is introduced to the aromatic ring and/or the hetero ring as a so-called side chain (Patent literature 5). However, the proposed method has a problem in that no material monomer for use in synthesizing such a polyazomethine is not commercially available.

In view of this problem, based upon the following two paradigm changes, the present inventors have invented a novel polyazomethine that is not only soluble in versatile organic solvents, but also is easily produced industrially, while securing carrier mobility sufficient for a semiconductor material.
(1) A carrier is allowed to be transferred not within a molecule, but among polymer molecules, by making a conjugated system (aromatic ring) possessed by the polymer stuck among polymer molecules (by making a conjugated structure oriented between the molecules), and
(2) an alkyl group or the like is introduced not as a polymer side chain, but as a one portion of a polymer main chain (that is, the conjugated structures are bonded to each other with a non-conjugated spacer).

The specific examples of the polyazomethine of the present invention include a polyazomethine having a repeating unit represented by the following formula (I):

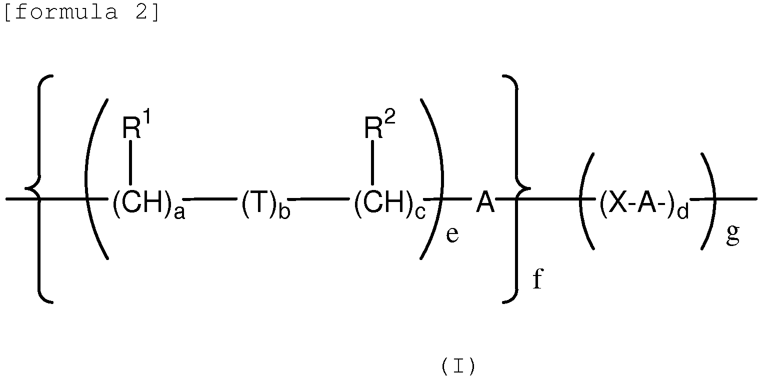

In the above-mentioned formula, each of R¹ and R² is a hydrogen atom, an alkyl group having 1 to 20 carbon atoms, a halogen atom, or a carboxyl group, independently;
A represents an azomethine group;
X represents a divalent aromatic group, which may have a substituent; and
T represents a divalent group having an oxygen atom, a sulfur atom, or a cycloalkylene group, and
b is 0 or 1;
each of a and c is an integer of 0 to 12 independently (in this case, when T is an oxygen atom or a sulfur atom, both of a and c are 1 or more);
d is an integer of 1 to 10;
e is an integer of 1 to 10;
each of f and g is an integer of 1 to 800 independently;
in the above-mentioned repeating unit, each of a hydrocarbon group represented by {((CHR¹)ₐ-(T)_{b}-(CHR²)_{c})ₑ-A-} and an aromatic ring-containing conjugated group represented by ((x-A)_{d}) are aligned in an arbitrary order,
when a is 2 or more, plural R¹'s may be the same or different,
when c is 2 or more, plural R²'s may be the same or different,
when d is 2 or more, plural X's may be the same or different,
when e is 2 or more, plural ((CHR¹)ₐ-(T)_{b}-(CHR²)_{c})'s may be the same or different,
when f is 2 or more, a plurality of the hydrocarbon groups may be the same or different, and
when g is 2 or more, a plurality of the aromatic-ring containing conjugated groups may be the same or different from each other, and
the number of carbon atoms in the hydrocarbon group is 3 to 43.

The polyazomethine of the present invention preferably has a weight-average molecular weight in a range of 2, 000 to 2, 000, 000, and the polyazomethine of the present invention has such a solubility that 0.1g or more thereof is dissolved at 25°C in 100g of a solvent or two kinds or more cosolvents normally selected from of the group consisting of cresol, toluene, THF, cyclopentyl methyl ether, acetone, MEK, MIBK, cyclopentanone, chloroform, dichloromethane, carbon tetrachloride, chlorobezene, carbon disulfide, ethyl acetate, butyl acetate, methyl lactate, methanol, ethanol, isopropyl alcohol, benzyl alcohol, n-butanol, t-butanol, pentyl alcohol, ethylene glycol, propylene glycol, propylene glycol monomethyl ether, pyridine, NMP, sulfuric acid, formic acid, acetic acid, hydrochloric acid, lactic acid, triethylamine and dibutylamine.

Specific examples of the divalent aromatic group in the aromatic ring-containing conjugated group include groups represented by the following formulas:

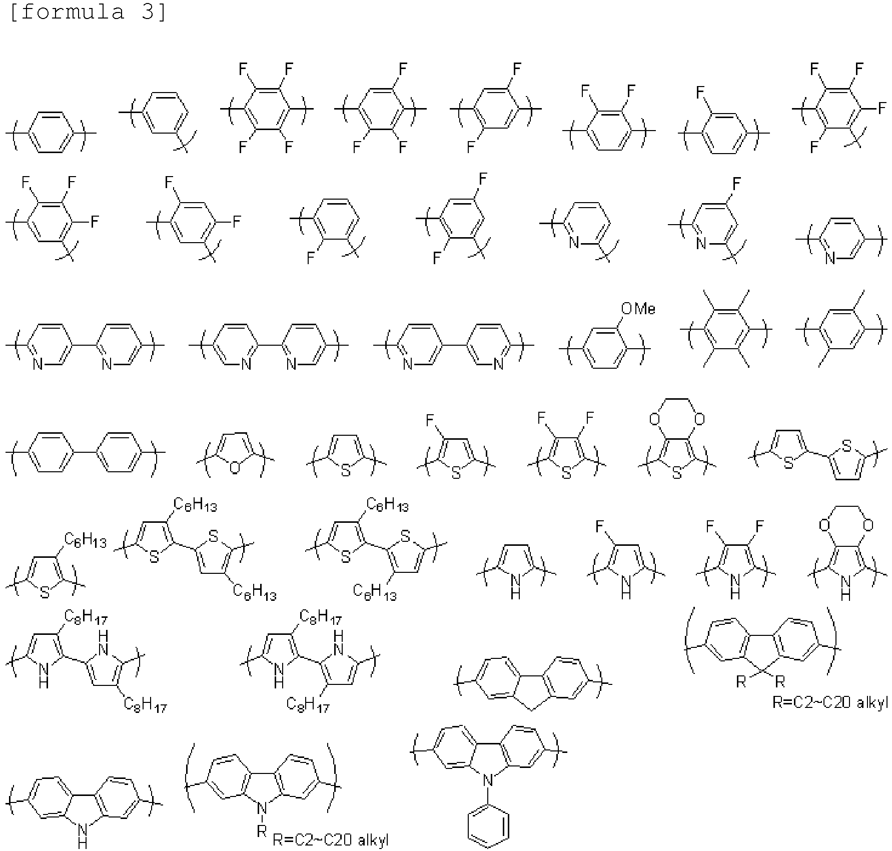

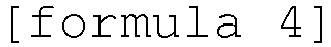

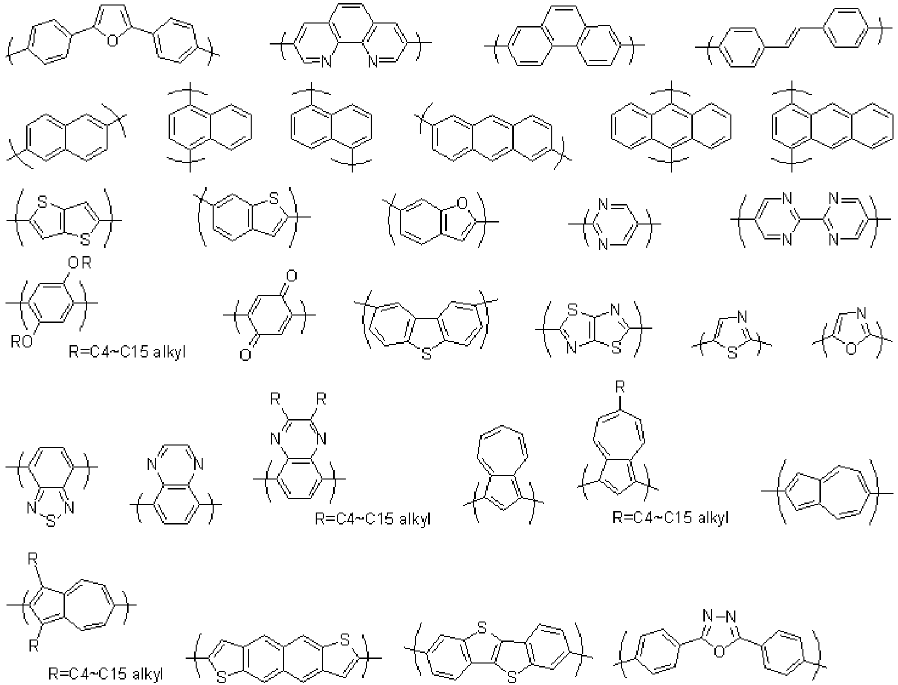

In the above formulas, a portion crossed by each parenthesis represents a bonding hand.

The polyazomethine of the present invention is preferably applicable to a semiconductor, and by applying it on the electrode as a film by using a coating method, a p-n junction element can be formed thereon. With respect to the p-n junction element formed by using the polyazomethine as a forming material for a P-type semiconductor layer or an N-type semiconductor layer, the polyazomethine of the present invention is characterized in that by connecting a positive electrode terminal to an electrode of the P-type semiconductor side, with a negative electrode terminal being connected to an electrode of the N-type semiconductor side, a voltage in a range of -5V to +5V can be applied thereto so that a ratio of an electric energy in a forward direction/an electric energy in a reverse direction > 1.0 can be satisfied.

The polyazomethine of the present invention can be produced by using a producing method having a process by which a hydrocarbon compound represented by the following formula (II) and an aromatic ring-containing compound represented by the following formula (III) are copolymerized with each other.

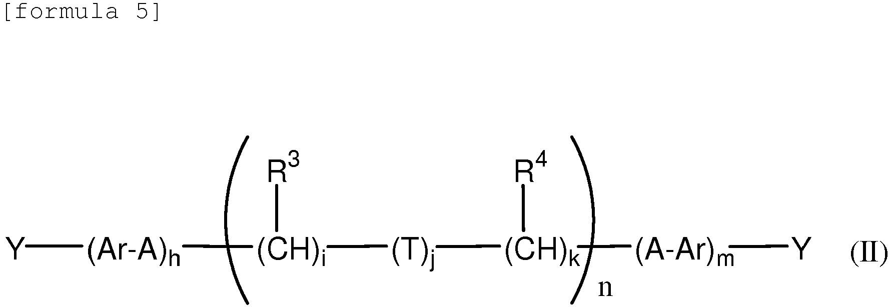

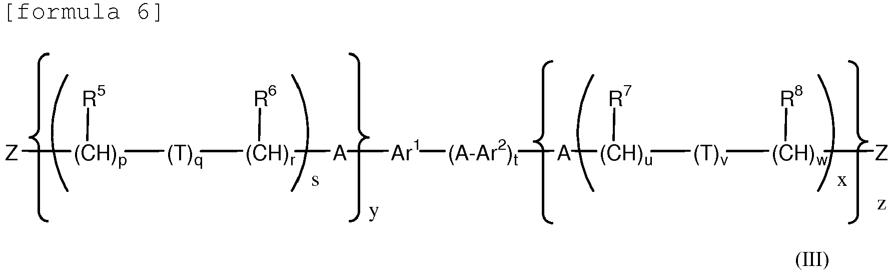

In the above formula (II), each of the two Y's represents an aldehyde group or an amino group;
A represents an azomethine group;
each of the two Ar's represents a divalent aromatic group that may have a substituent, independently; and
each of h and m is 0 or 1, independently;
each of R³ and R⁴ represents a hydrogen atom, an alkyl group having 1 to 20 carbon atoms, a halogen atom, or a carboxyl group, independently;
T represents a divalent group having an oxygen atom, a sulfur atom, or a cycloalkylene group;
j is 0 or 1;
each of i and k is an integer of 0 to 12 independently (in this case, when T is an oxygen atom or a sulfur atom, both of i and k are 1 or more);
n is an integer of 1 to 10;
when i is 2 or more, plural R³'s may be the same or different;
when k is 2 or more, plural R⁴'s may be the same or different;
when n is 2 or more, plural (-(CHR³)ᵢ-(T)ⱼ-(CHR⁴)ₖ-)'s may be the same or different;
a structure represented by (-(CHR³)ᵢ-(T)ⱼ-(CHR⁴)ₖ-)ₙ has 2 to 42 carbon atoms; and wherein
in the above formula (III), when Y in the formula (II) is an aldehyde group, each of the two Z's represents an amino group, and when the Y is an amino group, each of the two Z's represents an aldehyde group;
Ar¹ represents a divalent aromatic group, which may have a substituent;
Ar² represents a divalent aromatic group, which may have a substituent;
A is an azomethine group;
t is an integer of 0 to 8;
when t is 2 or more, plural Ar²'s may be the same or different;
each of R⁵ to R⁸ represents a hydrogen atom, an alkyl group having 1 to 20 carbon atoms, a halogen atom, or a carboxyl group, independently;
each of the two T's represents a divalent group having an oxygen atom, a sulfur atom, or a cycloalkylene group independently;
each of q and v is 0 or 1 independently;
each of p and r, as well as each of u and w, is an integer of 1 to 12 independently (in the case when T is an oxygen atom or a sulfur atom, each of p and r, as well as each of u and w, is 1 or more);
each of s and x is an integer of 1 to 10, independently;
when p is 2 or more, plural R⁵'s may be the same or different;
when r is 2 or more, plural R⁶'s may be the same or different;
when u is 2 or more, plural R⁷'s may be the same or different;
when w is 2 or more, plural R⁸'s may be the same or different;
when s is 2 or more, plural (-(CHR⁵)ₚ-(T)_{q}-(CHR⁶)ᵣ-)'s may be the same or different;
when x is 2 or more, plural (-(CHR⁷)ᵤ -(T)ᵥ-(CHR⁸)_{w}-)'s may be the same or different;
each of y and z is 0 or 1, independently; and
each a structure represented by (-(CHR⁵)ₚ -(T)_{q}-(CHR⁶)ᵣ-)ₛ and a structure represented by (-(CHR⁷)ᵤ-(T)ᵥ-(CHR⁸)_{w}-)ₓ has 2 to 42 carbon atoms.

Specific examples of the above aromatic ring-containing compound include compounds represented by the following formulas:

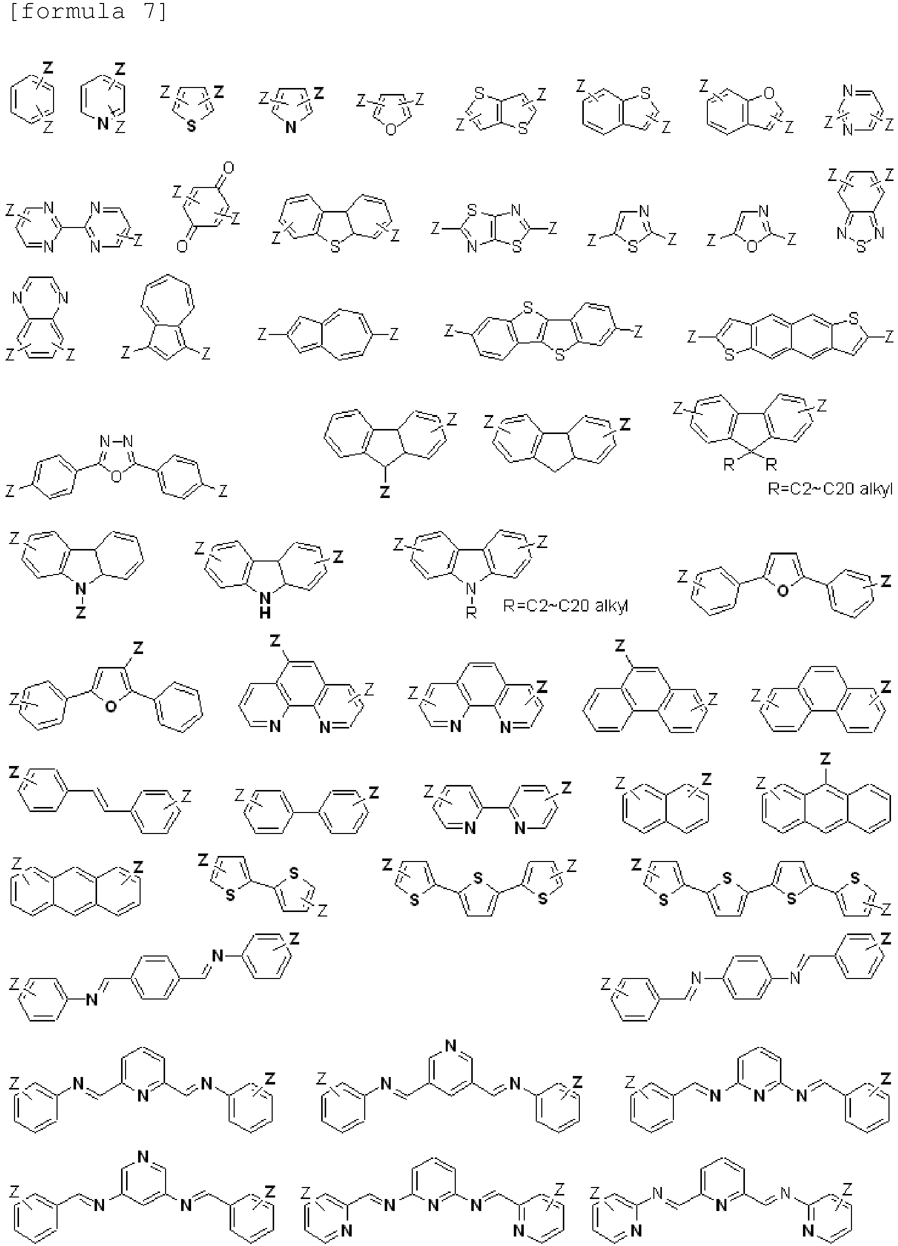

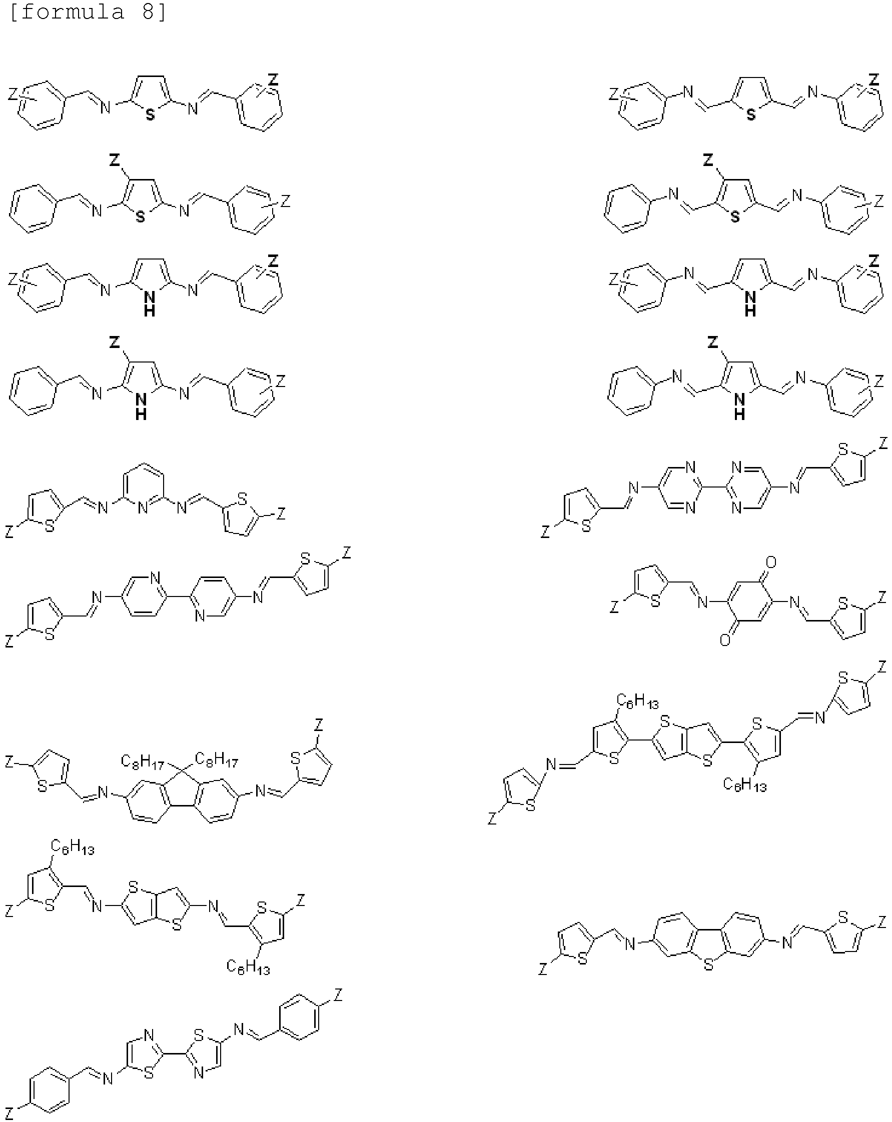

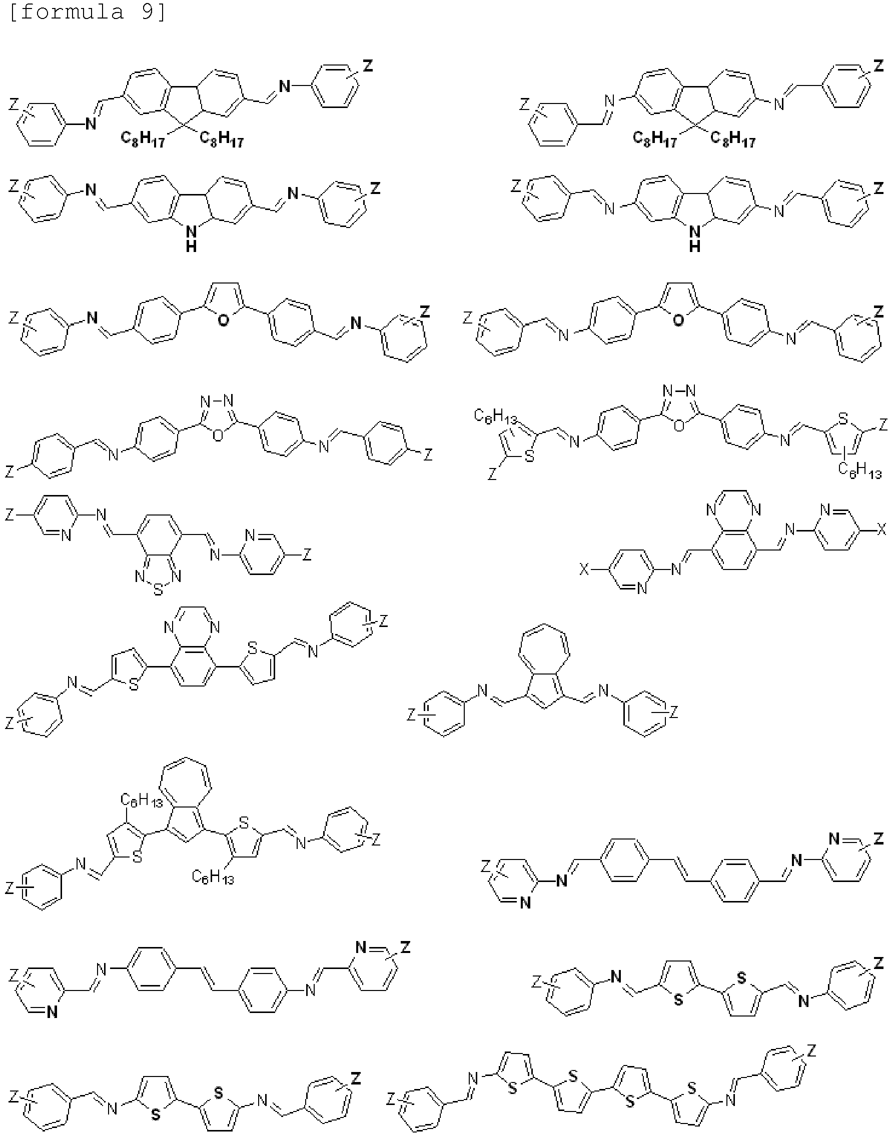

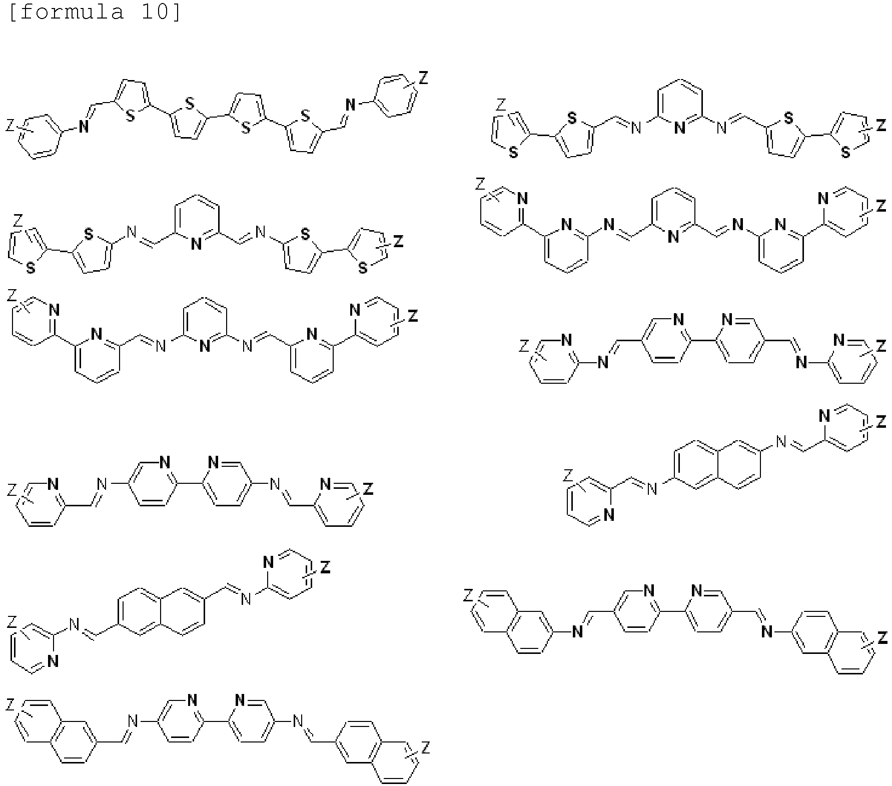

In the above formulas, z represents an aldehyde group or an amino group.

Moreover, the specific examples of the hydrocarbon compound include compounds represented by the following formulas:

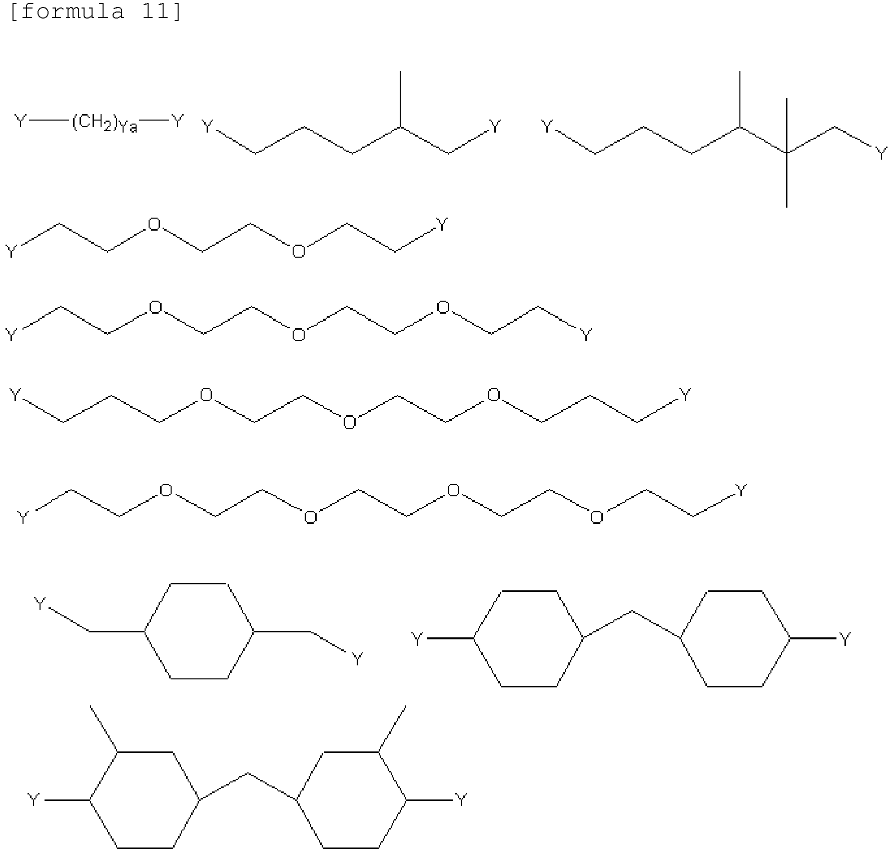

In the above formulas, Y represents an aldehyde group or an amino group, and Ya represents an integer of 6 to 12.

### ADVANTAGEOUS EFFECTS OF THE INVENTION

The polyazomethine of the present invention, which maintains carrier mobility sufficient for a semiconductor material, is highly soluble in versatile organic solvents including hydrophobic solvents such as toluene, alcohol solvents such as methanol and ethanol, glycol solvents such as propylene glycol monomethyl ether, and ester solvents such as methyl lactate.

For this reason, different from the conventional conjugated polymer that makes polyazomethine oriented on a substrate by a vacuum-vapor deposition method, the polyazomethine of the present invention makes it possible to form a semiconductor layer on a substrate by using a coating method.

### BRIEF DESCRIPTION OF THE DRAWINGS

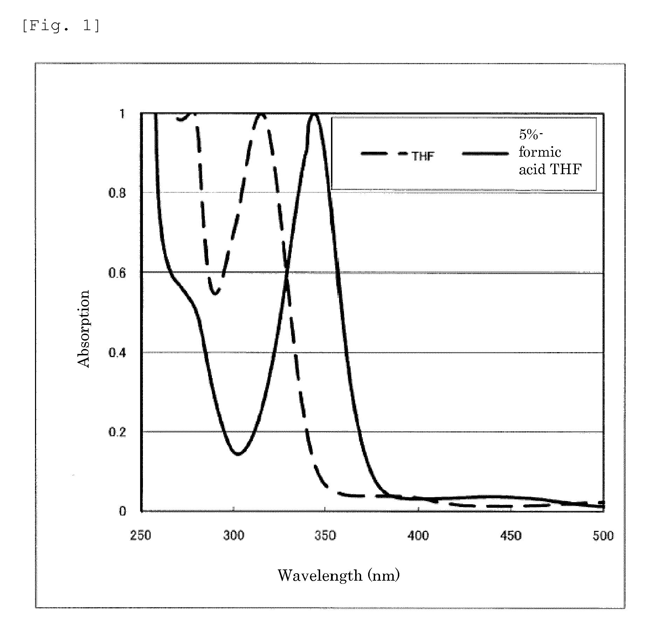

[FIG. 1] Fig. 1 shows the results of measurements of the ultraviolet-visible ray absorption spectrum in example 14 of a sample prepared by dissolving polyazomethine produced in example 4 in THF or a 5%-formic acid THF solution.

### DESCRIPTION OF EMBODIMENTS

### [Polyazomethine]

The following description will discuss the aromatic ring-containing conjugated group and the divalent hydrocarbon group possessed by the repeating unit forming the polyazomethine of the present invention in detail.

### <Aromatic Ring-Containing Conjugated Group>

As described earlier, the aromatic ring-containing conjugated group has a conjugated structure in which an azomethine group and a divalent aromatic group that may have a substituent are alternately bonded to one another.

By the conjugated structure of the aromatic ring-containing conjugated group, the polyazomethine of the present invention is allowed to have a carrier transporting capability.

Examples of the divalent aromatic group that may have a substituent include groups represented by the following formulas A-1 to A-24:

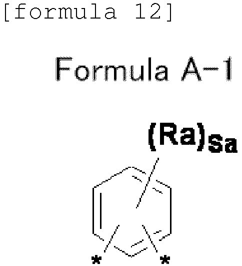

In formula A-1, Ra represents a hydrogen atom, a halogen atom, an alkyl group having 1 to 15 carbon atoms, or a hydrocarbon group having 1 to 15 carbon atoms, which includes an ether bond or an alkoxy group in the group. As the halogen atom, F, Cl and Br are listed. The same is true for the following formulas A-2 to A-24.

From the viewpoint of high crystallization between molecules of the polyazomethine of the present invention, Ra is preferably a hydrogen atom or a halogen atom, and more preferably a hydrogen atom because of its shorter van der Waals radius.

In formula A-1, Sa represents an integer of 1 to 4, and from the viewpoint of reducing the localization of electrons within the aromatic ring so as to provide high crystallization between molecules of the polyazomethine of the present invention, Sa is preferably prepared as an even number, and Sa is more preferably prepared as an even number and substituted so as to provide symmetrical elements for the aromatic group as a whole. The symmetrical elements relate not to the symmetry of the entire polyazomethine molecule, but to the symmetry of the structural portion of the aromatic group. Moreover, the symmetry refers to a symmetric property estimated from the structure drawn on paper, and does not refer to a symmetric property derived from a structure optimized by actually measured X-ray structural analysis and molecular orbital calculations. The same is true for the following description.

Additionally, in the case when Sa is 2 or more, plural Ra's may be the same or different.

Moreover, in formula A-1, "*" represents a bonding hand, and this is connected to the azomethine group. The same is true for the following formulas A-2 to A-24.

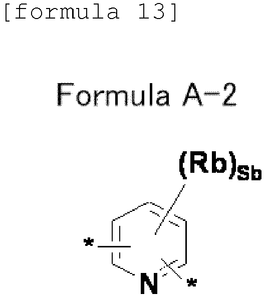

In formula A-2, Rb represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rb is preferably a hydrogen atom or a halogen atom, and more preferably a hydrogen atom because of its shorter van der Waals radius.

In formula A-2, Sb represents an integer of 1 to 3, and from the viewpoint of reducing the localization of electrons within the aromatic ring so as to provide high crystallization between molecules, Sb is preferably prepared as an odd number, and Sb is more preferably prepared as an odd number and substituted so as to provide symmetrical elements for the aromatic group as a whole. Here, in the case when Sb is 2 or more, plural Rb's may be the same or different.

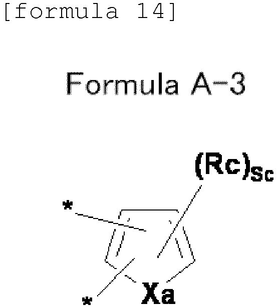

In formula A-3, Xa is a material selected from the group consisting of S, NH, N(CH₃),N(C₂H₅) and N(Ph), and from the viewpoint of high crystallization between molecules of the polyazomethine of the present invention, Xa is preferably selected from S and NH because of their small steric hindrance and high planarity.

In formula A-3, Rc represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rc is preferably a hydrogen atom or a halogen atom, and more preferably a hydrogen atom because of its shorter van der Waals radius.

In formula A-3, Sc is 1 or 2, and from the viewpoint of reducing the localization of electrons within the aromatic ring so as to provide high crystallization between molecules of the polyazomethine of the present invention, Sc is preferably 2, and Sc is more preferably prepared as 2 and is also substituted so as to provide symmetrical elements for the aromatic group as a whole. Here, in the case when Sc is 2 or more, the two Rc's may be the same or different.

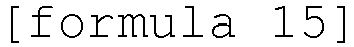

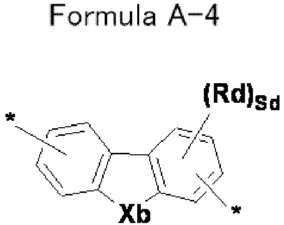

In formula A-4, Xb is a material selected from the group consisting of CH₂, (CₓH₂ₓ₊₁)₂ (X is an integer of 2 to 20), NH, N(CₓH₂ₓ₊₁) (X is an integer of 2 to 20), and N(Ph), and from the viewpoint of providing high crystallization between molecules of the polyazomethine of the present invention, Xb is preferably selected from CH₂ and NH because of their small steric hindrance and high planarity.

In formula A-4, Rd represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rd is preferably a hydrogen atom or a halogen atom, and more preferably a hydrogen atom because of its shorter van der Waals radius.

In formula A-4, Sd is an integer of 1 to 6. That is, although Rd is illustrated in formula A-4, as if bonded to a benzene ring on the right, Rd is bonded to all the carbon atoms to which it can be bonded in formula A-4. In other words, Rd may be bonded not only to the benzene ring on the right in formula A-4, but also to a benzene ring on the left. The same is true for the bonding hand. The same is also true in the following formulas A-5 to A-24.

From the viewpoint of reducing the localization of electrons within the aromatic ring so as to provide high crystallization between molecules of the polyazomethine of the present invention, Sd is preferably prepared as an even number, and Sd is more preferably prepared as an even number, with being also substituted so as to provide symmetrical elements for the aromatic group as a whole. Here, in the case when Sd is 2 or more, the plural Rd's may be the same or different.

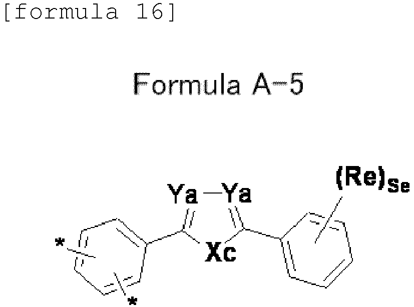

In formula A-5, Xc is a material selected from the group consisting of O, S, NH and N(CₓH₂ₓ₊₁) (X is an integer of 1 to 20) and N(Ph), and from the viewpoint of providing high crystallization between molecules of the polyazomethine of the present invention, Xc is preferably selected from O, S and NH because of their small steric hindrance and high planarity.

In formula A-5, Ya is selected from CH and N, and from the viewpoint of providing high crystallization between molecules of the polyazomethine of the present invention, either of them may be preferably used.

In formula A-5, Re represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Re is preferably a hydrogen atom or a halogen atom, and more preferably a hydrogen atom because of its shorter van der Waals radius.

In the case when Ya is CH in formula A-5, Se is an integer of 1 to 10, and from the viewpoint of reducing the localization of electrons within the aromatic ring so as to provide high crystallization between molecules of the polyazomethine of the present invention, Se is preferably prepared as an even number, and Se is more preferably prepared as an even number, with being also substituted so as to provide symmetrical elements for the aromatic group as a whole.

In the case when Ya is N, Se is an integer of 1 to 8, and from the viewpoint of reducing the localization of electrons within the aromatic ring so as to provide high crystallization between molecules of the polyazomethine of the present invention, Se is preferably prepared as an even number, and Se is more preferably prepared as an even number, with being also substituted so as to provide symmetrical elements for the aromatic group as a whole.

Here, in the case when Se is 2 or more, the plural Re's may be the same or different.

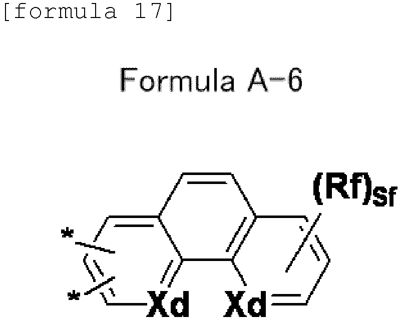

In formula A-6, Xd is selected from CH and N, and from the viewpoint of providing high crystallization between molecules of the polyazomethine of the present invention, either of them may be preferably used.

In formula A-6, Rf represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rf is preferably a hydrogen atom or a halogen atom, and more preferably a hydrogen atom because of its shorter van der Waals radius.

In the case when Xd is CH in formula A-6, Sf is an integer of 1 to 8, and from the viewpoint of reducing the localization of electrons within the aromatic ring so as to provide high crystallization between molecules of the polyazomethine of the present invention, Sf is preferably prepared as an even number, and Sf is more preferably prepared as an even number, with being also substituted so as to provide symmetrical elements for the aromatic group as a whole.

In the case when Xd is N, Sf is an integer of 1 to 6, and from the same viewpoint as described above, Sf is preferably prepared as an even number, and Sf is more preferably prepared as an even number, with being also substituted so as to provide symmetrical elements for the aromatic group as a whole.

Here, in the case when Sf is 2 or more, the plural Rf's may be the same or different.

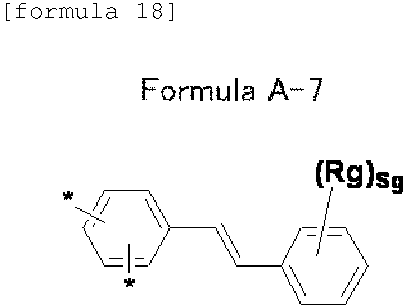

In formula A-7, Rg represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rg is preferably a hydrogen atom or a halogen atom, and more preferably a hydrogen atom because of its shorter van der Waals radius.

In formula A-7, Sg is an integer of 1 to 10, and Rg may be bonded to an ethylene group that connects two benzene rings with each other. From the viewpoint of reducing the localization of electrons within an aromatic ring so as to provide high crystallization between molecules of the polyazomethine of the present invention, Sg is preferably prepared as an even number, and Sg is more preferably prepared as an even number, with being also substituted so as to provide symmetrical elements for the aromatic group as a whole. In the case when Sg is 2 or more, the plural Rg's may be the same or different.

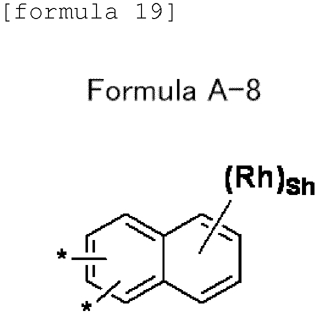

In formula A-8, Rh represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rh is preferably a hydrogen atom or a halogen atom, and more preferably a hydrogen atom because of its shorter van der Waals radius.

In formula A-8, Sh is an integer of 1 to 6, and from the viewpoint of reducing the localization of electrons within the aromatic ring so as to provide high crystallization between molecules of the polyazomethine of the present invention, Sh is preferably prepared as an even number, and Sh is more preferably prepared as an even number, with being also substituted so as to provide symmetrical elements for the aromatic group as a whole. In the case when Sh is 2 or more, the plural Rh's may be the same or different.

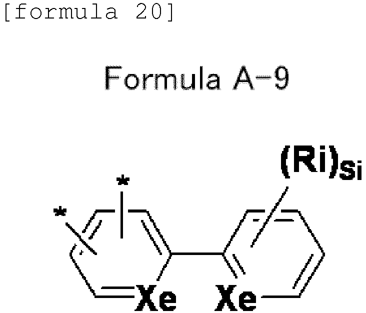

In formula A-9, Xe is selected from CH and N, and from the viewpoint of providing high crystallization between molecules of the polyazomethine of the present invention, Xe is preferably CH.

In formula A-9, Ri represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Ri is preferably a hydrogen atom or a halogen atom, and more preferably a hydrogen atom because of its shorter van der Waals radius.

In the case when Xe is CH in formula A-9, Si is an integer of 1 to 8, and from the viewpoint of reducing the localization of electrons within the aromatic ring so as to provide high crystallization between molecules of the polyazomethine of the present invention, Si is preferably prepared as an even number, and Si is more preferably prepared as an even number, with being also substituted so as to provide symmetrical elements for the aromatic group as a whole.

In the case when Xe is N, Si is an integer of 1 to 6, and from the same viewpoint as described above, Si is preferably prepared as an even number, and Si is more preferably prepared as an even number, with being also substituted so as to provide symmetrical elements for the aromatic group as a whole.

Here, in the case when Si is 2 or more, the plural Ri's may be the same or different.

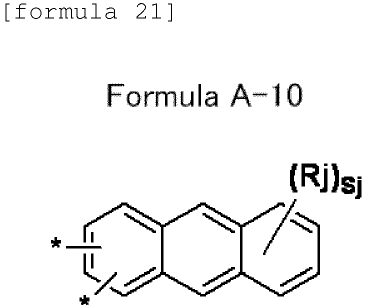

In formula A-10, Rj represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rj is preferably a hydrogen atom or a halogen atom, and more preferably a hydrogen atom because of its shorter van der Waals radius.

In formula A-10, Sj is an integer of 1 to 8, and from the viewpoint of reducing the localization of electrons within the aromatic ring so as to provide high crystallization between molecules of the polyazomethine of the present invention, Sj is preferably prepared as an even number, and Sj is more preferably prepared as an even number, with being also substituted so as to provide symmetrical elements for the aromatic group as a whole. In the case when Sj is 2 or more, the plural Rj's may be the same or different.

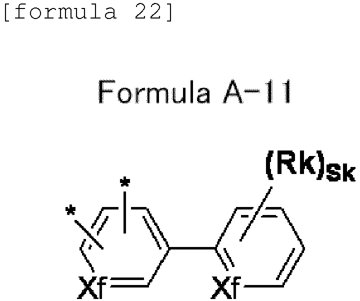

In formula A-11, Xf is selected from CH and N, and from the viewpoint of providing high crystallization between molecules of the polyazomethine of the present invention, Xf is preferably N.

In formula A-11, Rk represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rk is preferably a hydrogen atom or a halogen atom, and more preferably a hydrogen atom because of its shorter van der Waals radius.

In the case when Xf is CH in formula A-11, Sk is an integer of 1 to 8, and from the viewpoint of reducing the localization of electrons within the aromatic ring so as to provide high crystallization between molecules of the polyazomethine of the present invention, Sk is preferably prepared as an even number, and Sk is more preferably prepared as an even number, with being also substituted so as to provide symmetrical elements for the aromatic group as a whole.

In the case when Xf is N, Sk is an integer of 1 to 6, and from the same viewpoint as described above, Sk is preferably prepared as an even number, and Sk is more preferably prepared as an even number, with being also substituted so as to provide symmetrical elements for the aromatic group as a whole.

Here, in the case when Sk is 2 or more, the plural Rk's may be the same or different.

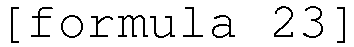

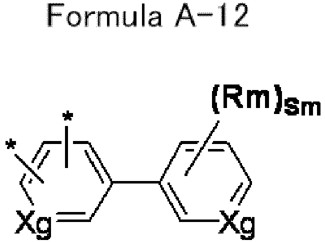

In formula A-12, Xg is selected from CH and N, and from the viewpoint of providing high crystallization between molecules of the polyazomethine of the present invention, Xg is preferably N.

In formula A-12, Rm represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rm is preferably a hydrogen atom or a halogen atom, and more preferably a hydrogen atom because of its shorter van der Waals radius.

In the case when Xg is CH in formula A-12, Sm is an integer of 1 to 8, and from the viewpoint of reducing the localization of electrons within the aromatic ring so as to provide high crystallization between molecules of the polyazomethine of the present invention, Sm is preferably prepared as an even number, and Sm is more preferably prepared as an even number, with being also substituted so as to provide symmetrical elements for the aromatic group as a whole.

In the case when Xg is N, Sm is an integer of 1 to 6, and from the same viewpoint as described above, Sm is preferably prepared as an even number, and Sm is more preferably prepared as an even number, with being also substituted so as to provide symmetrical elements for the aromatic group as a whole.

Here, in the case when Sm is 2 or more, the plural Rm's may be the same or different.

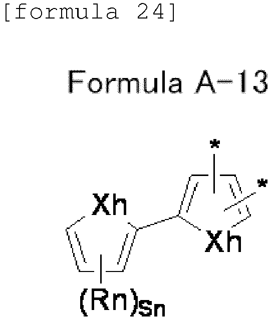

In formula A-13, Xh is selected from the group consisting of O, S, NH, N(CH₃), N(C₂H₅) and N(Ph), and from the viewpoint of providing high planarity of the intramolecular conjugated system of polyazomethine of the present invention, Xh is preferably S or NH.

In formula A-13, Rn represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rn is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-13, Sn is an integer of 1 to 4. In the case when Sn is 2 or more, the plural Rn's may be the same or different. From the viewpoint of reducing the localization of electrons within the aromatic ring so as to provide high crystallization between molecules of the polyazomethine of the present invention, Sn is preferably prepared as an integer of 2 to 4, and more preferably, 2 or 4.

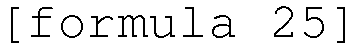

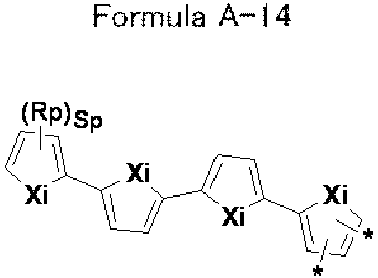

In formula A-14, Xi is selected from the group consisting of O, S, NH, N(CH₃), N(C₂H₅) and N(Ph), and from the viewpoint of providing high planarity of the intramolecular conjugated system of polyazomethine of the present invention, Xi is preferably S or NH.

In formula A-14, Rp represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rp is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-14, Sp is an integer of 1 to 8. In the case when Sp is 2 or more, the plural Rp's may be the same or different. From the viewpoint of reducing the localization of electrons within the aromatic ring so as to provide high crystallization between molecules of the polyazomethine of the present invention, Sp is preferably prepared as an integer of 4 to 8, and more preferably, 4 or 8.

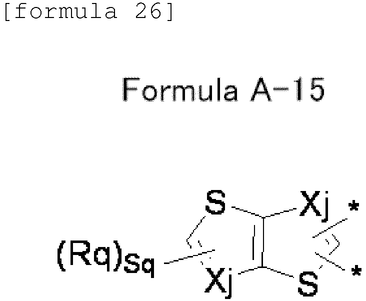

In formula A-15, Xj is selected from CH and N, and from the viewpoint of the commercial availability of materials for the polyazomethine of the present invention, Xj is preferably CH.

In formula A-15, Rq represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rq is preferably a hydrogen atom, an alkyl group having 1 to 8 carbon atoms, or an alkoxy group having 1 to 8 carbon atoms, and more preferably a hydrogen atom because of its shorter van der Waals radius.

In the case when Xj is CH in formula A-15, Sq is 1 or 2. In the case when Sq is 2, the two Rp's may be the same or different. From the viewpoint of reducing the localization of electrons within the aromatic ring so as to provide high crystallization between molecules of the polyazomethine of the present invention, Sq is preferably 2.

Additionally, in the case when Xj is N, Sq is 0.

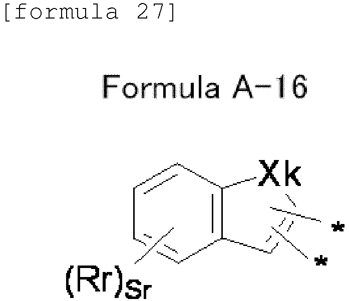

In formula A-16, Xk is selected from S and O, and from the viewpoint of the commercial availability of materials for the polyazomethine of the present invention, Xk is preferably S.

In formula A-16, Rr represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rr is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-16, Sr is an integer of 1 to 4. In the case when Sr is 2 or more, the plural Rr's may be the same or different. From the viewpoint of reducing the localization of electrons within the aromatic ring so as to provide high crystallization between molecules of the polyazomethine of the present invention, Sr is preferably 3 or 4, and more preferably 4.

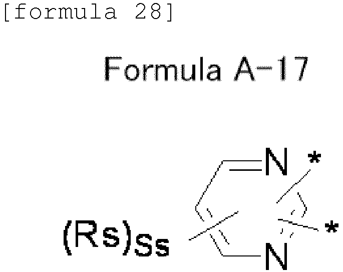

In formula A-17, Rs represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rs is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-17, Ss is 1 or 2. In the case when Ss is 2, the two Rs's may be the same or different. From the viewpoint of reducing the localization of electrons within the aromatic ring so as to provide high crystallization between molecules of the polyazomethine of the present invention, Ss is preferably 2.

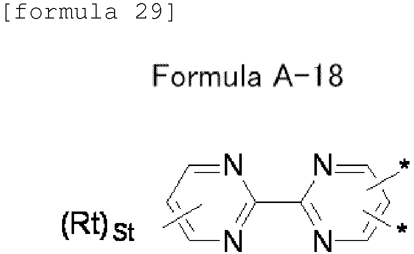

In formula A-18, Rt represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rt is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-18, St is an integer of 1 to 4. In the case when Sr is 2 or more, the plural Rt's may be the same or different. From the viewpoint of reducing the localization of electrons within the aromatic ring so as to provide high crystallization between molecules of the polyazomethine of the present invention, St is preferably an even number, with being substituted so as to provide symmetrical elements for the aromatic group as a whole.

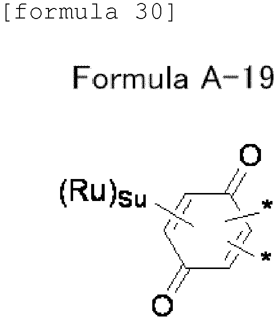

In formula A-19, Ru represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Ru is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-19, Su is 1 or 2. In the case when Su is 2, the two Ru's may be the same or different. From the viewpoint of reducing the localization of electrons within the aromatic ring so as to provide high crystallization between molecules of the polyazomethine of the present invention, Su is preferably 2, with being substituted so as to provide symmetrical elements for the aromatic group as a whole.

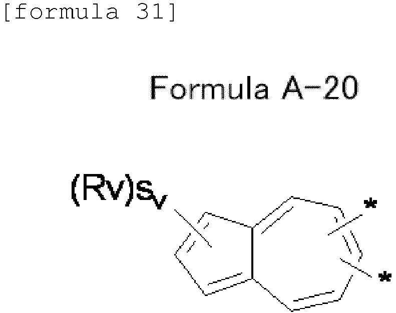

In formula A-20, Rv represents a hydrogen atom, a halogen atom, an alkyl group having 1 to 15 carbon atoms, or a hydrocarbon group having 1 to 15 carbon atoms that includes an ether bond or an alkoxy group in the group. From the viewpoint of providing high crystallization between molecules of the polyazomethine of the present invention, Rv is preferably a hydrogen atom, an alkyl group having 1 to 15 carbon atoms, or an alkoxy group having 1 to 15 carbon atoms, and more preferably a hydrogen atom because of its shorter van der Waals radius.

In formula A-20, Sv is an integer of 1 to 6. In the case when Sv is 2 or more, the plural Rv's may be the same or different. From the viewpoint of reducing the localization of electrons within the aromatic ring so as to provide high crystallization between molecules of the polyazomethine of the present invention, Sv is an even number, with being preferably substituted so as to provide symmetrical elements for the aromatic group as a whole.

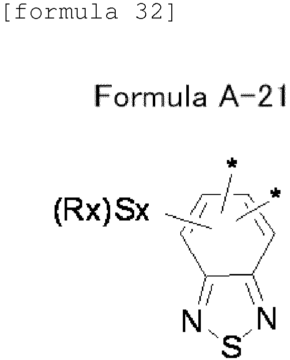

In formula A-21, Rx represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rx is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-21, Sx is 1 or 2. In the case when Sx is 2, the two Rx's may be the same or different. From the viewpoint of reducing the localization of electrons within the aromatic ring so as to provide high crystallization between molecules of the polyazomethine of the present invention, Sx is preferably 2.

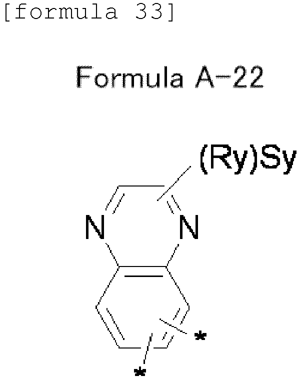

In formula A-22, Ry represents a hydrogen atom, a halogen atom, an alkyl group having 1 to 15 carbon atoms, or a hydrocarbon group having 1 to 15 carbon atoms that includes an ether bond or an alkoxy group in the group. From the viewpoint of providing high crystallization between molecules of the polyazomethine of the present invention, Ry is preferably a hydrogen atom, an alkyl group having 1 to 15 carbon atoms, or an alkoxy group having 1 to 15 carbon atoms, and more preferably a hydrogen atom because of its shorter van der Waals radius.

In formula A-22, Sy is an integer of 1 to 4. In the case when Sy is 2 or more, the plural Ry's may be the same or different. From the viewpoint of reducing the localization of electrons within the aromatic ring so as to provide high crystallization between molecules of the polyazomethine of the present invention, Sy is preferably an even number, with being preferably substituted so as to provide symmetrical elements for the aromatic group as a whole.

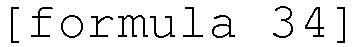

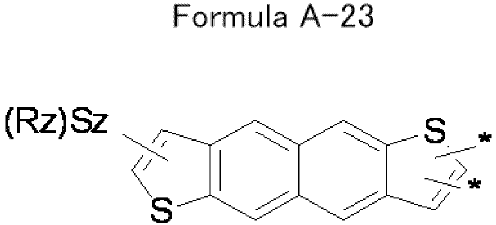

In formula A-23, Rz represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Rz is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-23, Sz is an integer of 1 to 6. In the case when Sz is 2 or more, the plural Rz's may be the same or different. From the viewpoint of reducing the localization of electrons within the aromatic ring so as to provide high crystallization between molecules of the polyazomethine of the present invention, Sz is preferably an even number, with being substituted so as to provide symmetrical elements for the aromatic group as a whole.

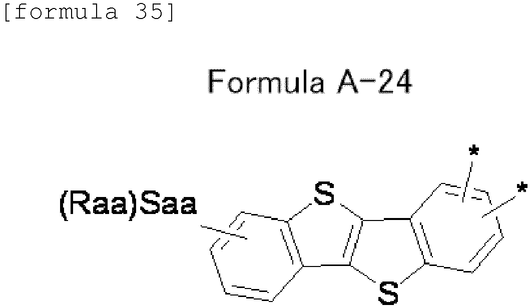

In formula A-24, Raa represents a hydrogen atom, a halogen atom, an alkyl group having 1 to 8 carbon atoms, or a hydrocarbon group having 1 to 8 carbon atoms that includes an ether bond or an alkoxy group in the group. From the viewpoint of providing high crystallization between molecules of the polyazomethine of the present invention, Raa is preferably a hydrogen atom, an alkyl group having 1 to 8 carbon atoms, or an alkoxy group having 1 to 8 carbon atoms, and more preferably a hydrogen atom because of its shorter van der Waals radius.

In formula A-24, Saa is an integer of 1 to 6. In the case when Saa is 2 or more, the plural Raa's may be the same or different. From the viewpoint of reducing the localization of electrons within the aromatic ring so as to provide high crystallization between molecules of the polyazomethine of the present invention, Saa is preferably an even number, with being preferably substituted so as to provide symmetrical elements for the aromatic group as a whole.

As more specific examples for the above-described groups represented by formulas A-1 to A-24, groups represented by the following formulas are proposed.

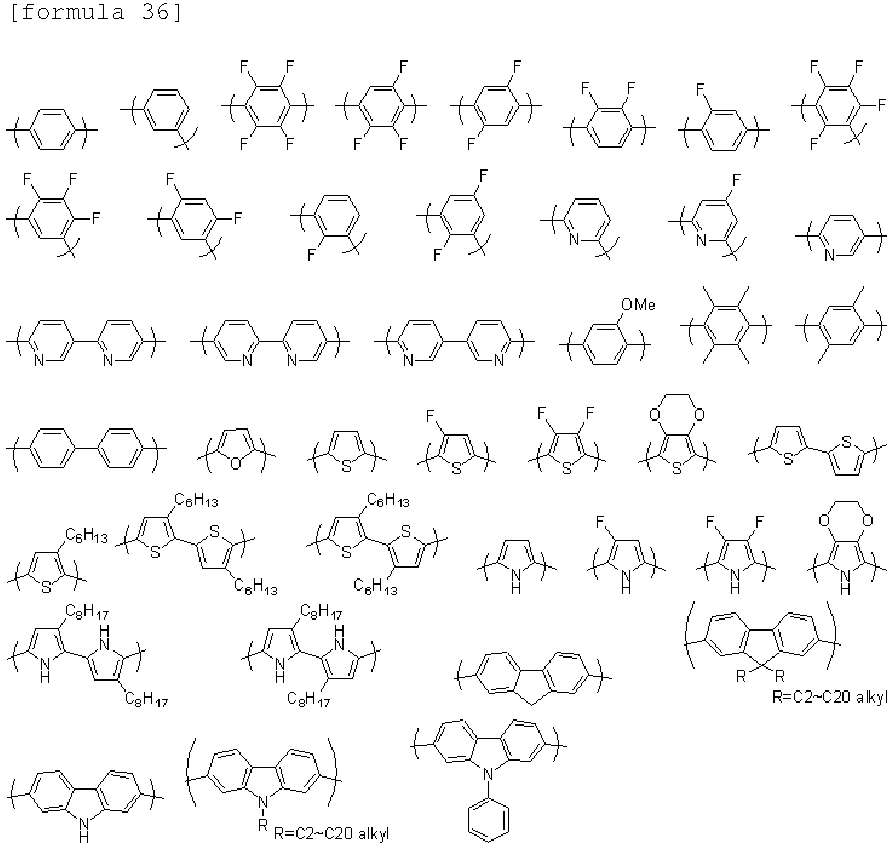

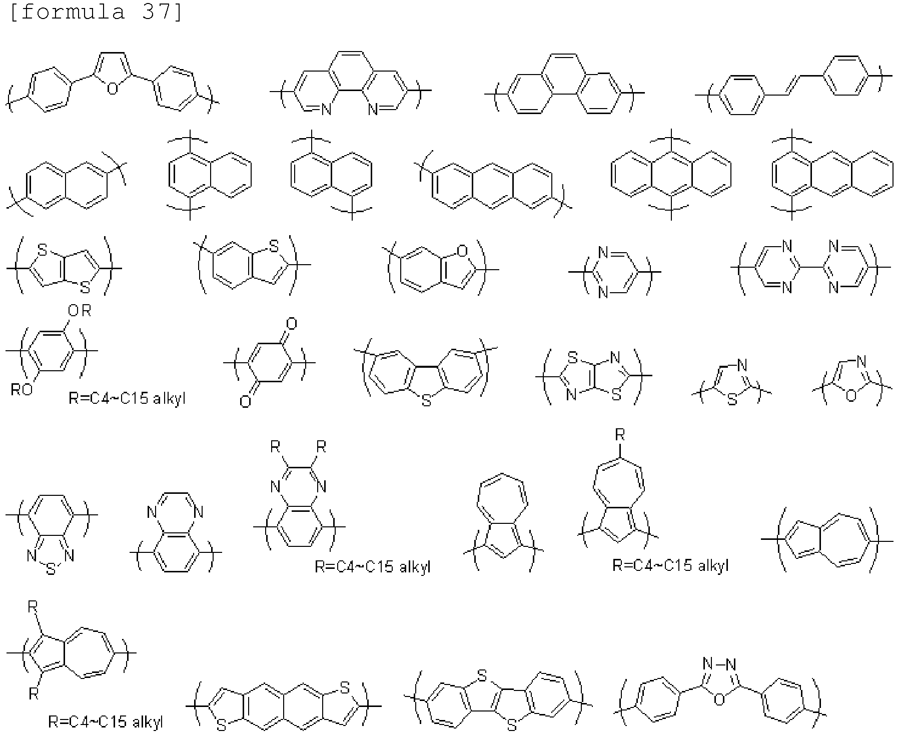

In the above formula, a portion crossed by each parenthesis represents a bonding hand.

In the above-described aromatic ring-containing conjugated group, the divalent aromatic groups are bonded to each other by an azomethine group, and the azomethine group and the divalent aromatic group are alternately bonded to one another into a conjugated structure. Additionally, the number of the divalent aromatic groups may be one.

The number of the aromatic groups in the aromatic ring-containing conjugated group is normally 5 or less, and from the viewpoint of solubility to a solvent, the intermolecular conjugation and the crystallinity among the molecules of the polyazomethine of the present invention, the number thereof is preferably set to 1 to 5. The method for allowing the azomethine group and the divalent aromatic group to be alternately bonded to each other will be described later in the description of the production method for polyazomethine of the present invention.

With respect to the number of the aromatic ring-containing conjugated groups within a repeating unit forming the polyazomethine of the present invention, a single or a plurality thereof may be used (in the case of a plurality thereof, in each repeating unit, the aromatic ring-containing conjugated group and a hydrocarbon group are alternately arranged) . The number of the aromatic ring-containing conjugated groups in each repeating unit is preferably set to 1 to 6, from the view point of accelerating crystallization among the polyazomethine molecules.

### <Divalent Hydrocarbon Group>

The divalent hydrocarbon group may have a group having an oxygen atom, a sulfur atom, or a cycloalkylene group, and is not particularly limited, unless it is conjugated with an azomethine group. While the aromatic ring-containing conjugated group has a rigid structure, the hydrocarbon group has a flexible structure because it is not conjugated with the azomethine group. The fact that the polyazomethine of the present invention has this hydrocarbon group having a flexible structure devotes to high solubility of the polyazomethine of the present invention to an organic solvent, which will be described later.

Examples of the divalent hydrocarbon group include an alkylene group having 2 to 42 carbon atoms that may have a branch or may be substituted with a halogen atom, a divalent hydrocarbon group having 2 to 42 carbon atoms that has an ether bond and/or a thioether bond in the group and may be substituted with a halogen atom, a cycloalkylene group having 3 to 42 carbon atoms that may have a substituent, and a divalent hydrocarbon group having 2 to 42 carbon atoms that has a carboxyl group in the group, and may be substituted with a halogen atom.

Examples of the halogen atom include a fluorine atom, a chlorine atom and a bromine atom.

Examples of the substituent in the cycloalkylene group include a halogen atom, an alkyl group having 1 to 6 carbon atoms, and an alkoxy group having 1 to 6 carbon atoms. Moreover, the cycloalkylene group may have a plurality of ring structures, and the ring structures may be bonded to each other with an alkylene group.

The number of carbon atoms of the alkylene group that may have a branch and may be substituted with a halogen atom is preferably set to 3 to 20, more preferably, 4 to 12, and further preferably, 6 to 12, from the viewpoints of both of the affinity to an organic solvent and intermolecular crystallinity in a solid state of the polyazomethine of the present invention.

The number of carbon atoms of the divalent hydrocarbon group that has an ether bond and/or a thioether bond in the group, and may be substituted with a halogen atom is preferably set to 3 to 20, more preferably, 4 to 12, and further preferably, 6 to 12, from the viewpoints of both of the affinity to an organic solvent and intermolecular crystallinity in a solid state of the polyazomethine of the present invention.

The number of carbon atoms of the cycloalkylene group that may have a substituent is preferably set to 3 to 30, and preferably, 6 to 15, from the viewpoints of both of the affinity to an organic solvent and intermolecular crystallinity in a solid state of the polyazomethine of the present invention.

The number of carbon atoms of the divalent hydrocarbon group that has a carboxyl group in the group and may be substituted with a halogen atom is preferably set to 3 to 20, more preferably, 4 to 12, and further preferably, 6 to 12, from the viewpoints of both of the affinity to an organic solvent and intermolecular crystallinity in a solid state of the polyazomethine of the present invention.

The divalent hydrocarbon group forming the repeating unit of the polyazomethine of the present invention preferably has a comparatively low polarity such as toluene from the viewpoint of affinity to an organic solvent, and also preferably has a structure including an alkylene group so as to be allowed to exert solubility to a solvent having a high hydrophobicity. Moreover, so as to be allowed to exert solubility to an alcohol-based, glycol-based and ester-based solvent, the hydrocarbon group preferably has a structure having an ether bond in the group. So as to be allowed to exert solubility to a halogen-containing solvent, the hydrocarbon group preferably has a structure having a halogen atom (substituted with a halogen atom).

In the repeating unit forming the polyazomethine of the present invention, the number of the divalent hydrocarbon groups may be one, or may be a plurality thereof (in the case of a plurality thereof, in each repeating unit, the hydrocarbon group and the aromatic ring-containing conjugated group are alternately arranged). The number of the hydrocarbon groups in the repeating unit is preferably set to 1 to 6, from the viewpoint of accelerating the solubility to a solvent and the crystallinity among the molecules.

### <Repeating Unit Forming the Polyazomethine of the Present Invention>

The polyazomethine of the present invention, which has the above-described aromatic ring-containing conjugated group and hydrocarbon group, is characterized by including a repeating unit in which the aromatic ring-containing conjugated group and the hydrocarbon group are boned to each other via an azomethine group. The method for bonding the two groups to each other via the azomethine group will be explained later in the description of the production method for polyazomethine of the present invention.

Specific examples of the repeating unit forming the polyazomethine of the present invention include a repeating unit represented by the following formula (I):

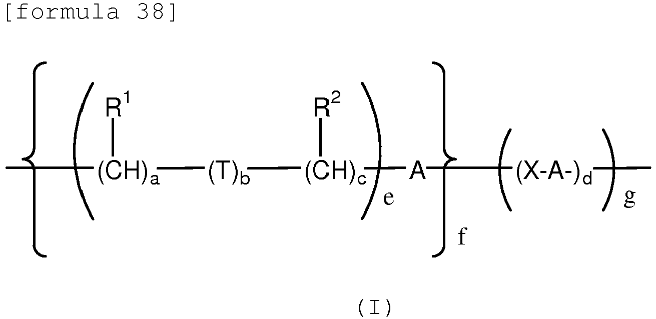

In the above formula, R¹ and R² represent a hydrogen atom, an alkyl group having 1 to 20 carbon atoms, a halogen atom, or a carboxyl group, independently. From the viewpoint of the solubility to an organic solvent and the crystallinity of a film upon forming the film, R¹ and R² are preferably prepared as a hydrogen atom or an alkyl group having 5 to 12 carbon atoms.

In the above formula (I), A represents an azomethine group. The azomethine group refers to a -C=N- or -N=C- group. The conjugated state within the conjugated system differs depending on the orientation of this azomethine group; however, it is considered that the conjugated state does not have great influences on the crystallinity among the molecules in a non-heteroatom-containing aromatic ring, such as a phenyl group. On the other hand, in the case when the aromatic ring is a hetero ring, such as a pyridine group, it is considered that depending on the orientation of the azomethine group, the conjugated state gives influences on the crystallinity among the molecules. In other words, in the case when the orientation of the azomethine group is such that, of N and C forming the azomethine group, N is located closer to the hetero ring, with the hetero atom of the hetero ring being located closer to N forming the azomethine group, an expansion of the conjugated system within the molecule occurs in a solid state of polyazomethine of the present invention, desirably giving great influences on the electron structure within the conjugated system. It is expected that in its liquid state, the polyazomethine of the present invention exerts a metalating effect, a cation recognizing effect, etc. to metal ions, based upon N in the azomethine group and the hetero atom in the hetero ring, thereby making it possible to template the polyazomethine because of the interaction of the above effects.

In the above formula (I), X represents a divalent aromatic group that may have a substituent. Specific examples of X are the same as those proposed as specific examples of a divalent aromatic group that may have a substituent in the above description

### <Aromatic Ring-Containing Conjugated Group>.

In the above formula (I), T represents a divalent group having an oxygen atom, a sulfur atom, or a cycloalkylene group, and from the viewpoint of the commercial availability of the materials, an oxygen atom is preferably used.

In the above formula (I), b represents 0 or 1, and in the case when b is 1, the hydrocarbon group in the above-mentioned repeating unit has an ether bond (oxygen atom), a thioether bond (sulfur atom), or a cycloalkylene group.

In the above formula (I), a and c are integers of 0 to 12 independently, and preferably, prepared as 1 and an integer of 5 to 12. In the case when T is an oxygen atom or a sulfur atom, both of a and c are 1 or more.

Moreover, in the case when a is 2 or more, the plural R¹'s may be the same or different, and in the case when c is 2 or more, the plural R²'s may be the same or different.

In the above formula (I), d is an integer of 1 to 10, and preferably, an integer of 1 to 3. In the case when d is 2 or more, the plural X's may be the same or different.

In the formula (I), e represents an integer of 1 to 10, and preferably, an integer of 3 to 5. With respect to a portion within parentheses with a subscript e, that is, (-(CHR¹)a -(T)_{b}-(CHR²)_{c}), in the case when e is 2 or more, a plurality thereof are present, and in such a case, these may be the same or different.

In the formula (I), f and g are integers of 1 to 800, independently, and preferably, integers of 2 to 500. In this case, when f is 2 or more, the plural hydrocarbon groups, each represented by {(-(CHR¹)ₐ-(T)_{b}-(CHR²)_{c})ₑ-A-}, may be the same or different, and when g is 2 or more, the plural aromatic ring-containing conjugated groups, each represented by ((X-A)_{d}), may be the same or different. In this case, the number of carbon atoms in the hydrocarbon group is normally set to 3 to 43, and preferably, 6 to 37.

Moreover, in the repeating unit forming the polyazomethine of the present invention, although the hydrocarbon group and the aromatic ring-containing conjugated group can be arranged in a desired order, they are basically arranged alternately. With respect to the method for adjusting the order of alignment of the hydrocarbon groups and the aromatic ring-containing conjugated groups in the repeating unit forming the polyazomethine of the present invention, an explanation will be given later in the description of the production method for the polyazomethine of the present invention.

### <Polyazomethine>

The polyazomethine of the present invention having the above-mentioned repeating unit is provided with the divalent hydrocarbon group in its structure, and since this portion has no crystallinity, it is allowed to exert high solubility to various versatile organic solvents, such as hydrophobic solvents, alcohol solvents, glycol solvents, or ester solvents.

More specifically, the polyazomethine has such a solubility that 0.1g or more thereof, preferably, 1 to 10g thereof, is dissolved at 25°C in 100g of a solvent or two kinds or more cosolvents normally selected from of the group consisting of cresol, toluene, THF, cyclopentyl methyl ether, acetone, MEK, MIBK, cyclopentanone, chloroform, dichloromethane, carbon tetrachloride, chlorobenzene, carbon disulfide, ethyl acetate, butyl acetate, methyl lactate, methanol, ethanol, isopropyl alcohol, benzyl alcohol, n-butanol, t-butanol, pentyl alcohol, ethylene glycol, propylene glycol, propylene glycol monomethyl ether, pyridine, NMP, sulfuric acid, formic acid, acetic acid, hydrochloric acid, lactic acid, triethylamine and dibutylamine. Additionally, as described in "BACKGROUND ART", materials, such as cresol, chlorobenzene are corrosive, or harmful to the human body. In the present invention, these are normally added to a versatile solvent such as toluene in a small amount, and used as a cosolvent.

As described above, the polyazomethine of the present invention, which exerts high solubility to various versatile organic solvents, has a high carrier transporting capability, such as electrons and holes, and is desirably used for the semiconductor application, although it has no conjugated structure over the entire molecules, which makes it different from the conventional polyazomethine.

The reason why the polyazomethine of the present invention has a high carrier transporting capability is explained as follows: That is, in the polyazomethine, those mutual components having high affinity (that is, in the case of hydrocarbon groups, the mutual hydrocarbon groups, while in the case of aromatic ring-containing conjugated group, the mutual aromatic ring-containing conjugated groups) are overlapped with each other. Moreover, at portions where the aromatic ring-containing conjugated groups are stuck on each other, carriers are allowed to move freely. In other words, in the case of the conventional polyazomethine, the carrier mobility is ensured by utilizing the conjugated state inside the molecule and the stacking structure between the molecules, on the sacrifice of the solubility to a solvent; however, in the present invention, by cutting off the conjugated state inside the molecule, the solubility to a solvent is ensured, and in the same manner as in the case of orienting a low molecular component by using a vacuum vapor deposition, by treating a conjugated portion like the low molecular component in polyazomethine, the conjugated portion is oriented by the stacked state of the molecules so that the carrier mobility is ensured.

As described above, the polyazomethine of the present invention has a high carrier transporting capability and is desirably used for the semiconductor application, while ensuring high solubility to versatile organic solvents. Therefore, by dissolving the polyazomethine in a versatile organic solvent, a polyazomethine solution is prepared, and by using the resultant solution, a semiconductor layer can be safely and easily formed on a substrate safely by using a coating method, such as a spin coating method and a dip coating method.

The solution of the polyazomethine of the present invention having such a carrier transporting capability is applied onto an electrode to form a film thereon so that a p-n junction element can be produced. In the case when the polyazomethine is used as a P-type semiconductor layer forming material, an N-type semiconductor layer is formed by using a semiconductor material (for example, fullerene) with an electron affinity (eV) having a value higher than an ionization potential (eV) of the polyazomethine. Moreover, in the case when the polyazomethine is used as an N-type semiconductor layer forming material, a P-type semiconductor layer is formed by using a semiconductor material (for example: poly(3-hexylthiophene)) with an ionization potential having a value lower than an electron affinity (eV) of the polyazomethine.

More specifically, in the case when the polyazomethine of the present invention is used as an N-type semiconductor layer forming material, the polyazomethine solution is applied onto the negative side electrode substrate, and dried it to form a film, and on the film, a P-type semiconductor material is applied or vapor-deposited thereto to form a film thereon, and by vapor-depositing a positive side electrode on the resultant P-type semiconductor layer so that a p-n junction element can be manufactured. Moreover, in the case when the polyazomethine of the present invention is used as a P-type semiconductor layer forming material, the N-type semiconductor material is applied or vapor-deposited onto the negative side electrode substrate to form a film thereon, and on the film, the polyazomethine solution is applied and dried it to form a P-type semiconductor layer, and by further vapor-depositing a positive electrode on the P-type semiconductor layer, a p-n junction element can be manufactured. The thickness of the junction layer of these P-type and N-type semiconductor materials is normally 10 to 900 nm. The p-n junction element, for example, formed in this manner, can be applied to the field of organic electronics, such as diodes, organic EL's, organic thin-film solar batteries, organic thin-film transistors, thermoelectric generator elements.

In this case, the ionization potential and electron affinity can be experimentally found respectively as HOMO (Highest Occupied Molecular Orbital) and LUMO (Lowest Unoccupied Molecular Orbital).

The HOMO can be found by using an AC-2 made by Riken Keiki Co., Ltd. through a photoelectron spectroscopic method disclosed in Japanese Patent No. 1124703.

Moreover, as a method for finding an electrochemical oxidation potential and for converting it to the HOMO, a method is specifically exemplified in which an oxidation starting potential of a sample is found and converted.

The oxidation starting potential is found through processes in which measurements on cyclic voltammetry (CV) are carried out on a target sample and based upon the results of the measurements, the starting potential is found as a potential at the time when an oxidation current starts to flow from the base line. If necessary, conversion is carried out from the reference electrode used for the measurements to a standard hydrogen electrode reference, and by further adding a value (constant) 4.5 of the standard hydrogen electrode relative to the vacuum level to this value, the HOMO (eV) can be obtained.

Next, as a method for finding the LUMO, a method in which by finding an electrochemical reduction level, the resulting value is converted to the LUMO, and a method in which, based upon the absorption starting wavelength of ultraviolet-visible light absorption spectrum of the sample and the value of HOMO found as described above, the value of the HOMO is converted to the LUMO are proposed.

In the case of finding the LUMO by electrochemical measurements, in the same manner as in the case of finding the HOMO, a reduction potential of the sample is measured by CV, and by carrying out the same conversion, the LUMO can be found.

In the case of finding the LUMO based upon the absorption starting wavelength, the sample is applied onto a glass substrate to form a film having a thickness of about several tens of nano meters by a spin coating, and measurements of ultraviolet-visible light absorption spectra are carried out on the film thus formed, and the absorption starting wavelength can be found from the measurement result as a wavelength λ (nm) at the time when the absorption starts from the base line. This value is converted to an electron volt (eV) so that the resulting value is defined as a band gap energy E(eV). Moreover, by dividing the HOMO (eV) found as described above by this band gap energy E(eV), the LUMO can be found.

With respect to adjustments of the semiconductor characteristics of polyazomethine, general findings about conjugated-type polymers can be referred to, and by the same method as the general adjusting method, the adjustments of the semiconductor characteristics can be carried out.

The P-type semiconductor characteristics of the polyazomethine of the present invention can be improved by adjusting the ionization potential of the molecules. For example, the ionization potential of the molecules can be increased by, for example, the following two methods.
(1) As a conjugated system (aromatic ring-containing conjugated group), a condensed ring-type unit having abundant electrons, such as naphthalene, anthracene is selected.
(2) By introducing an electron donating substituent, such as a methyl group, a phenyl group into the conjugated system, the electron density in the conjugated system is increased so that electrons are delocalized.

On the other hand, the N-type semiconductor characteristics of the polyazomethine of the present invention can be improved by adjusting electron affinity of molecules. For example, the electron affinity of molecules can be increased by the following two methods.
(1) As a conjugated system (aromatic ring-containing conjugated group), a hetero-ring, such as pyridine, bipyridine, phenanthroline, that has a tendency of lacking electrons is selected.
(2) By introducing an electron absorbing substituent, such as F, CF₃, the electron density in the conjugated system is lowered so that electrons are localized.

The polyazomethine of the present invention having superior semiconductor characteristics as described above makes it possible to prepare a p-n junction element. With respect to the p-n junction element formed by using the polyazomethine as the forming material for the P-type semiconductor layer or the N-type semiconductor layer, by connecting a positive electrode terminal to the electrode of the P-type semiconductor side, with a negative electrode terminal being connected to the electrode of the N-type semiconductor side, a voltage in a range of -5V to +5V can be applied thereto, and a ratio of an electric energy in the forward direction/an electric energy in the reverse direction > 1.0 is satisfied.

By utilizing this characteristic, the polyazomethine of the present invention can be applied as, for example, p- and n-type semiconductors. Additionally, between the P-type semiconductor layer and the electrode as well as between the N-type semiconductor layer and the electrode, a hole injection layer and an electron injection layer may be respectively formed in a separate manner.

Moreover, from the viewpoint of satisfying both of the solvent solubility and the intramolecular crystallinity, the weight-average molecular weight of the polyazomethine of the present invention is preferably in a range of 2, 000 to 2, 000, 000, and more preferably, in a range of 30,000 to 1,500,000. In the present specification, the weight average molecular weight refers to a weight-average molecular weight measured through GPC, based upon the standard polystyrene calibration. With respect to an adjusting method for the weight-average molecular weight, an explanation will be given in the description of the production method for the polyazomethine of the present invention below.

In the polyazomethine of the present invention described above, even in a portion among molecules at which the aromatic ring-containing conjugated group is stacked, carriers can be freely moved; therefore, this structure is desirable for semiconductor applications, and the polyazomethine has high solubility to a versatile organic solvent, such as a hydrophobic solvent, an alcohol solvent, a glycol solvent or an ester solvent.

Moreover, as described earlier, in the case when the aromatic ring in the aromatic ring-containing conjugated group of the polyazomethine of the present invention is a hetero-ring such as a pyridine group, if the azomethine group is oriented such that of N and C forming the azomethine group, N is located at a position closer to the hetero-ring, with the hetero atom in the hetero-ring being located closer to N forming the azomethine group, an expansion occurs in an intermolecular conjugated system in a solid state of the polyazomethine of the present invention to sometimes cause great influences to the electron structure inside the conjugated system.

As examples of the polyazomethine of the present invention, a hetero-ring compound (left side in the following formula) that satisfies the above-mentioned conditions, and a compound (right side in the following formula) having a plurality of hetero-rings, with the hetero atoms of the different hetero-rings being located close to each other, are proposed.

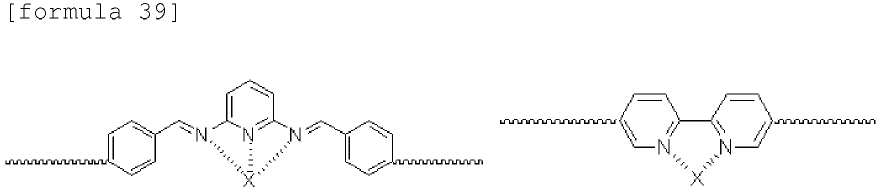

By the hetero atom in this hetero ring-containing compound and the imine nitrogen of the azomethine group, or hetero atoms mutually located close to one another of a plurality of hetero-rings, the polyazomethine of the present invention is allowed to react with various Lewis acids or metals to produce polymer complexes, such as Lewis acid-base complexes and metalated complexes. With this arrangement, further adjustments of the semiconductor characteristics, such as improvements of the planarity of the conjugated structure portion of the polyazomethine of the present invention, the HOMO-LUMO energy level, electron affinity, ionization potential, band gap, and carrier service life thereof, can be carried out.

The following description will discuss the production method for polyazomethine in accordance with the present invention.

### [Production Method for Polyazomethine]

A production method for polyazomethine of the present invention is characterized by a step of copolymerizing a hydrocarbon compound represented by the following formula (II) with an aromatic ring-containing compound represented by the following formula (III).

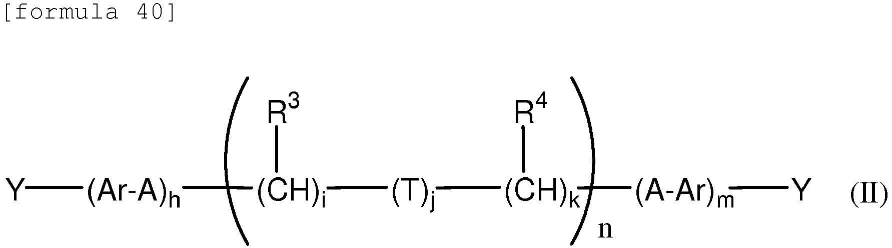

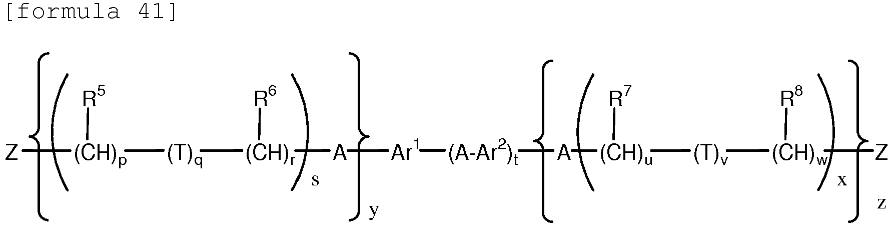

(III)

In formula (II), both of two Y's are aldehyde groups or amino groups, and in formula (III), in the case when Y's in formula (II) are aldehyde groups, two Z's are amino groups, and in the case when Y's therein are amino groups, the two Z's are aldehyde groups.

In other words, by utilizing the reaction of the aldehyde group and the amino group, the hydrocarbon compound and the aromatic ring-containing compound are alternately reacted with one after another so that polyazomethine of the present invention is obtained.

The following description will discuss these hydrocarbon compounds represented by formula (II) and aromatic ring-containing compounds represented by formula (III).

### <Hydrocarbon Compounds Represented by Formula (II)>

In the above formula (II), both of the two Y's are aldehyde groups or amino groups, as described above.

In formula (II), A represents an azomethine group, and as will be described later, the orientation thereof is different depending on the selection of a compound for use as a material matrix for producing a hydrocarbon compound.

In formula (II), each of two Ar's is a divalent aromatic group that may have a substituent, independently. Specific examples of Ar are the same as those exemplified as specific examples of the divalent aromatic groups which may have a substituent in the aforementioned description of <Aromatic Ring-Containing Conjugated Group>.

In formula (II), h and m are 0 or 1, independently. In the case when h or m is 1, an A-Ar-Y group (in which Y forms an azomethine group) forms an aromatic ring-containing conjugated group in the polyazomethine of the present invention, or one portion thereof. Whether it forms the aromatic ring-containing conjugated group or it forms one portion thereof is dependent on the structure of a hydrocarbon compound and the structure of an aromatic ring-containing compound represented by formula (III), as will be described later. From the viewpoint of improving the polymerization activity between the hydrocarbon compound and the aromatic ring-containing compound, h and m are preferably set to 0.

In formula (II), each of R³ and R⁴ is a hydrogen atom, an alkyl group having 1 to 20 carbon atoms, a halogen atom, or a carboxyl group, independently, and from the viewpoint of providing good solubility to an organic solvent and high crystallization of a film upon film formation, each of them is preferably a hydrogen atom or an alkyl group having 5 to 12 carbon atoms.

In formula (II), T represents a divalent group having an oxygen atom, a sulfur atom or a cycloalkylene group, and from the viewpoint of the commercial availability of the material, each of them is preferably an oxygen atom.

In formula (II), j is 0 or 1, and in the case when j is 1, the polyazomethine of the present invention obtained by using such a hydrocarbon compound is allowed to have a divalent hydrocarbon group having an ether bond (oxygen atom), a thioether bond (sulfur atom), or a cycloalkylene group. From the viewpoint of improving the solubility to an organic solvent, j is preferably 1.

In formula (II), i and k are integers of 0 to 12, independently, and preferably, prepared as 1 and an integer of 5 to 12. However, in the case when T is an oxygen atom or a sulfur atom, both of i and k are 1 or more.

Additionally, in the case when i is 2 or more, the plural R³'s may be the same or different, and in the case when k is 2 or more, the plural R⁴'s may be the same or different.

In formula (II), n is an integer of 1 to 10, and preferably an integer of 3 to 5. In the case when n is 2 or more, there are a plurality of portions, each enclosed in parentheses with a subscript n, that is, (-(CHR³)ᵢ -(T)ⱼ-(CHR⁴)ₖ-), and these may be the same or different. Moreover, the number of carbon atoms in the structure represented by (-(CHR³)ᵢ -(T)ⱼ-(CHR⁴)ₖ-)ₙ is set to 2 to 42, and preferably, to 5 to 36.

### (Method for Obtaining Hydrocarbon Compound Represented by Formula (II))

Compounds in formula (II) in which h and m are 0 are commercially available, and easily obtained.

The compounds in which one of h and m is 1, with the other being 0, are easily obtained by allowing commercially available products to react with each other.

In the case of exemplifying a structure in which, in formula (II), Ar is a phenylene group, h is 1, the group represented by (-(CHR³)ᵢ -(T)ⱼ-(CHR⁴)ₖ-)ₙ is an octylene group, and m is 0, a hydrocarbon compound of formula (II) can be obtained by the following reaction:

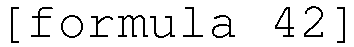

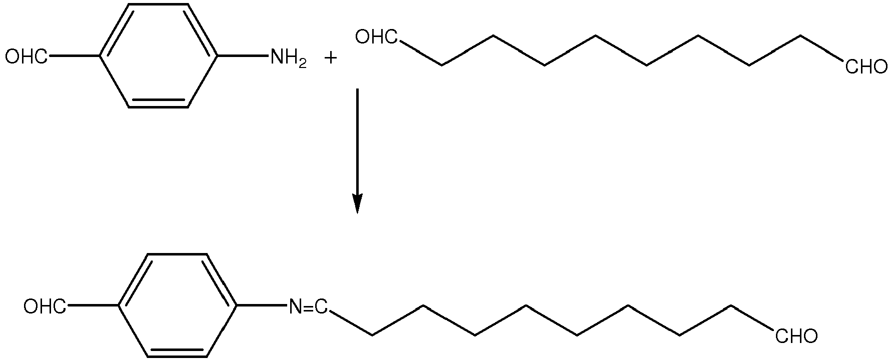

The detailed reaction conditions of such a reaction by which one molecule of p-aminobenzaldehyde is reacted with one molecule of 1, 8-diformyloctane so that a hydrocarbon compound represented by formula (II) is obtained are explained in the description of synthesis of material 1 in examples.

In the above reaction, a hydrocarbon compound having an aldehyde group as Y is obtained, and when the reaction materials to be used are changed to p-aminobenzaldehyde and 1,8-diaminooctane, a hydrocarbon compound having an amino group as Y, with the orientation of the azomethine group being reversed, can be obtained.

Moreover, a hydrocarbon compound in which both of the h and m are 1 can be obtained by repeating the above reaction (by allowing the compound obtained by the above reaction to further react with p-aminobenzaldehyde). Furthermore, as indicated by the following formula, the compound is also obtained by a reaction of one stage. Additionally, the following formula exemplifies a structure in which the group represented by (-(CHR³)ᵢ -(T)ⱼ-(CHR⁴)ₖ-)ₙ is a dodecylene group, in formula (II).

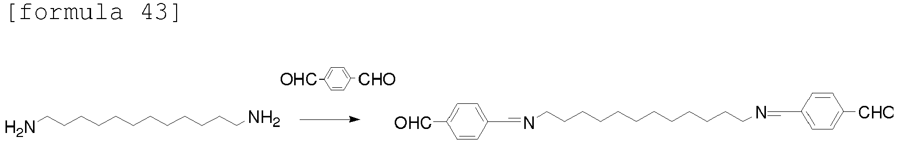

By applying an excessive amount (two times or more) of p-aminobenzaldehyde to 1,12-diaminododecane, the above-mentioned reaction of one stage can be carried out. In the above-mentioned reaction, a hydrocarbon compound having aldehyde groups on two terminals of its molecule is obtained; however, when the reaction materials to be used are changed to 1,12-diformyldodecane and 1,4-diaminobenzene, a hydrocarbon compound having amino groups on two terminals of its molecule, with the orientation of the azomethine group being reversed, can be obtained.

Since the amino group and the aldehyde group have high reactivity, the above-mentioned reaction easily proceeds by, for example, making the material components in contact with each other to be mixed with each other.

This reaction can be carried out under commonly used known reaction conditions in which the amino group and the aldehyde group are reacted with each other, and the reaction temperature is normally set to 30 to 120°C, with the reaction time being normally set to 2 to 48 hours.

Moreover, examples of the reaction solvent to be used include: an ester-based solvent, such as ethyl acetate or butyl acetate, an aromatic solvent, such as toluene or xylene, an ether-based solvent, such as THF or cyclopentyl methyl ether, a ketone-based solvent, such as MEK or cyclopentanone, a proton-donor-type aromatic solvent, such as m-cresol or phenol (preferably applied under an acid-catalyzed reaction condition), a halogen-containing solvent, such as chloroform, methylene chloride , tetrachloroethane or chlorobenzene, a proton-accepting-type solvent, such as NMP, DMF, pyridine or piperidine (preferably applied under a base-catalyzed reaction condition), and a nitrile-based solvent, such as acetonitrile or benzonitrile.

As described above, hydrocarbon compounds serving as production materials for polyazomethine of the present invention are commercially available, or can be easily obtained by allowing those commercial products to react with each other.

### (Specific Examples of Hydrocarbon Compounds)

Specific examples of a hydrocarbon compound represented by the above-mentioned formula (II) include compounds represented by the following formulas:

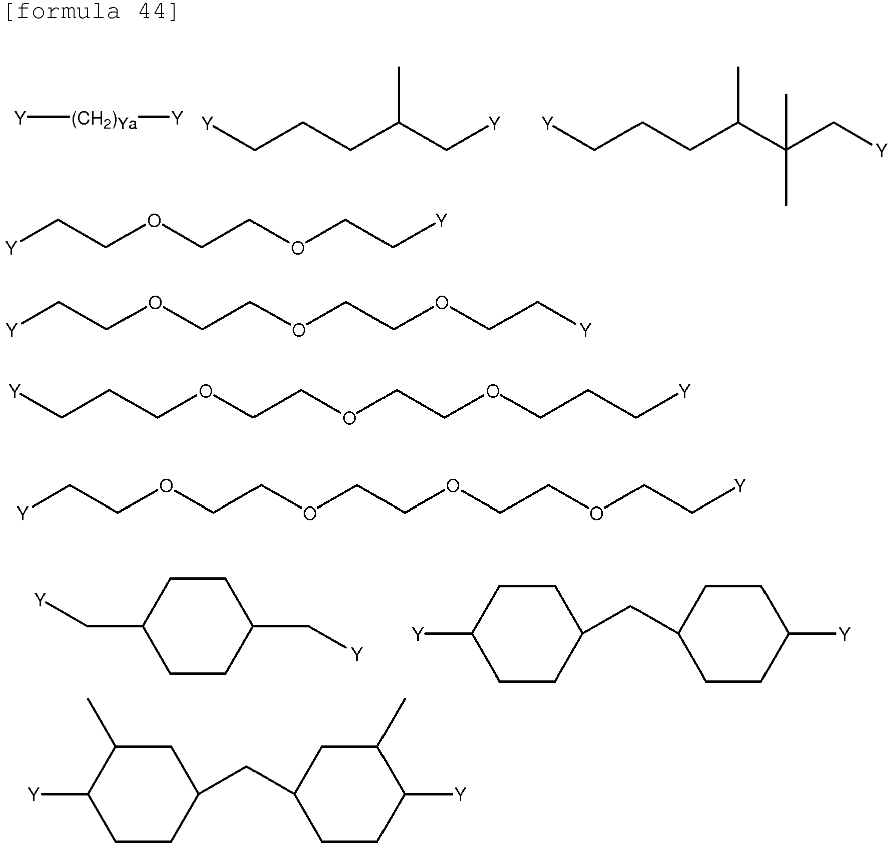

In the above-mentioned formulas, Y represents an aldehyde group or an amino group, and Ya is an integer of 6 to 12.

### <Aromatic Ring-Containing Compound Represented by Formula (III)>

The aforementioned formula (III) is again shown.

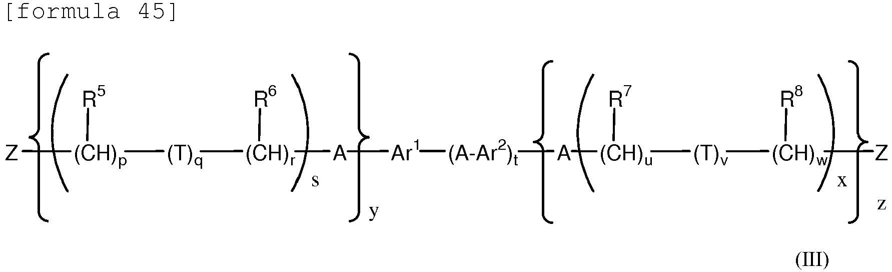

In formula (III), when Y in the above formula (II) is an aldehyde group, each of the two Z's represents an amino group, and when the Y is an amino group, each of them represents an aldehyde group.

In formula (III), each of Ar¹ and Ar² represents a divalent aromatic group that may have a substituent, independently. Specific examples of the aromatic group are the same as those divalent aromatic groups, each of which may have a substituent, proposed as specific examples in the description of <Aromatic Group Ring-Containing Conjugated Group>.

In formula (III), A is an azomethine group, and as will be described later, the direction thereof is made different depending on the selection of a compound to be used as a material matrix for producing an aromatic ring-containing compound.

In formula (III), t is an integer of 0 to 8, and preferably, an integer of 1 to 3. Moreover, when t is 2 or more, plural Ar²'s may be the same or different.

In formula (III), each of the two T's represents a divalent group having an oxygen atom, a sulfur atom, or a cycloalkylene group, independently.

In formula (III), each of q and v is 0 or 1 independently, and in the case when q or v is 1 (accurately, when q is 1 and y is 1, or when v is 1 and z is 1), polyazomethine of the present invention, obtained by using such an aromatic ring-containing compound, has an aromatic ring-containing conjugated group having an ether bond (oxygen atom), a thioether bond (sulfur atom), or a cycloalkylene group in its repeating unit.

In formula (III), each of R⁵ to R⁸ represents a hydrogen atom, an alkyl group having 1 to 20 carbon atoms, a halogen atom, or a carboxyl group, independently, and from the viewpoint of solubility to an organic solvent and crystallinity of a film upon forming the film, they are preferably prepared as an alkyl group having 5 to 12 carbon atoms.

In formula (III), each of p and r, as well as each of u and w, is an integer of 0 to 12, and preferably, an integer of 5 to 12 independently. In the case when T is an oxygen atom or a hydrogen atom, each of p and r, as well as each of u and w, is 1 or more.

Moreover, when p is 2 or more, plural R⁵'s may be the same or different, when r is 2 or more, plural R⁶'s may be the same or different, when u is 2 or more, plural R⁷'s may be the same or different, and when w is 2 or more, plural R⁸'s may be the same or different.

In formula (III), each of s and x is an integer of 1 to 10 independently, and preferably, an integer of 3 to 5. In the case when s is 2 or more, there are a plurality of portions, each enclosed in parentheses with a subscript n, that is, (-(CHR⁵)ₚ -(T)_{q}-(CHR⁶)ᵣ-), and these may be the same or different. In the case when x is 2 or more, there are a plurality of portions, each enclosed in parentheses with a subscript x, that is, (-(CHR⁷)ᵤ -(T)ᵥ-(CHR⁸)_{w}-), and these may be the same or different.

Moreover, the number of carbon atoms in each of the structure represented by (-(CHR⁵)ₚ -(T)_{q}-(CHR⁶)ᵣ-)ₛ and the structure represented by (-(CHR⁷)ᵤ-(T)ᵥ-(CHR⁸)_{w}-)ₓ is set to 2 to 42 independently, and preferably, to 5 to 36.

In formula (III), y and z are 0 or 1 independently, and from the viewpoint of improving the polymerization activity between the hydrocarbon compound and the aromatic ring-containing compound, they are preferably set to 0. In the case when y or z is 1, a portion enclosed in parentheses with the subscript attached thereto forms a divalent hydrocarbon group in the repeating unit forming polyazomethine of the present invention or one portion thereof. Whether the portion forms the divalent hydrocarbon group or it forms one portion thereof is determined depending on the hydrocarbon compound represented by formula (II) or the aromatic ring-containing compound represented by formula (III).

For example, in the case when h is 1 and m is 0 in a hydrocarbon compound and y and z are 1 in an aromatic ring-containing compound, with a portion 1 enclosed by parentheses with a subscript y attached thereto in formula (III) and a portion 2 enclosed by parentheses with a subscript n attached thereto in formula (II) being copolymerized in a manner so as to be adjacent to each other through an azomethine group, each of the portion 1 and portion 2 forms one portion of the divalent hydrocarbon group in the repeating unit, and a portion 3 enclosed by parentheses with a subscript z attached thereto forms the divalent hydrocarbon group in the repeating unit. Moreover, a portion 4 enclosed by parentheses with a subscript h attached thereto and a group Ar¹-(A-Ar²)ₜ respectively form aromatic ring-containing conjugated groups in the repeating unit.

### (Method for Obtaining Aromatic Ring-Containing Compound Represented by Formula (III))

Compounds represented by formula (III) in which y and z are 0 are commercial products, and easily available.

Moreover, an aromatic ring-containing compound having the structure in which y or z is 1 and the other is 0 can be easily obtained by allowing commercial products to react with each other.

In the case when, for example, in formula (III), y is 1, (-CHR⁵)ₚ-(T)_{q}-(CHR⁶)ᵣ-)ₛ is an octylene group, t is 0, Ar¹ is a phenylene group, and z is 0, an aromatic ring-containing compound can be obtained by the following reactions.

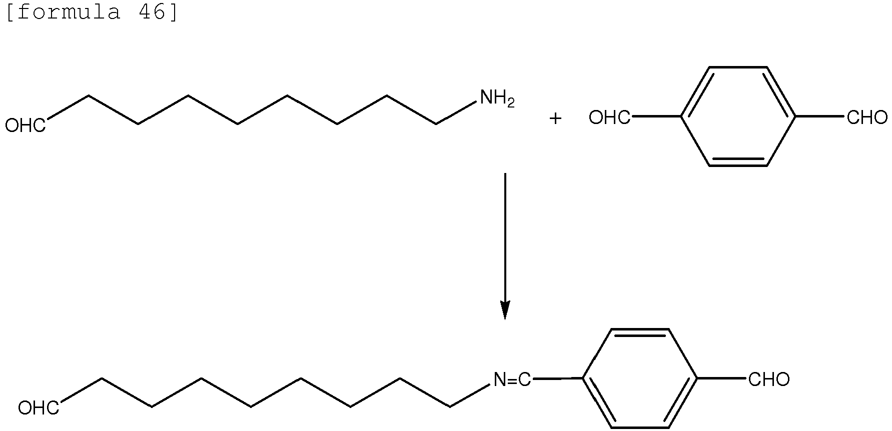

Reaction conditions of such a reaction in which one molecule of 8-aminooctanal is reacted with one molecule of 1,4-diformylbenzene(terephthalaldehyde) to provide the aromatic ring-containing compound represented by formula (III) will be described in detail in the description of a synthesis of material 1 of examples.

In the above-mentioned reaction, an aromatic ring-containing compound having an aldehyde group as Z is obtained; however, in the case when the reaction materials to be used are changed to 8-aminooctanal and 1,4-diaminobenzene, an aromatic ring-containing compound having an amino group as Z, with the orientation of the azomethine group being reversed, can be obtained.

Moreover, the aromatic ring-containing compound in which both of y and z are 1 is obtained by repeating the above-mentioned reaction (the compound obtained in the above reaction is further reacted with 8-aminooctanal), and the compound can also be obtained by a reaction of one stage as shown in the following formula:

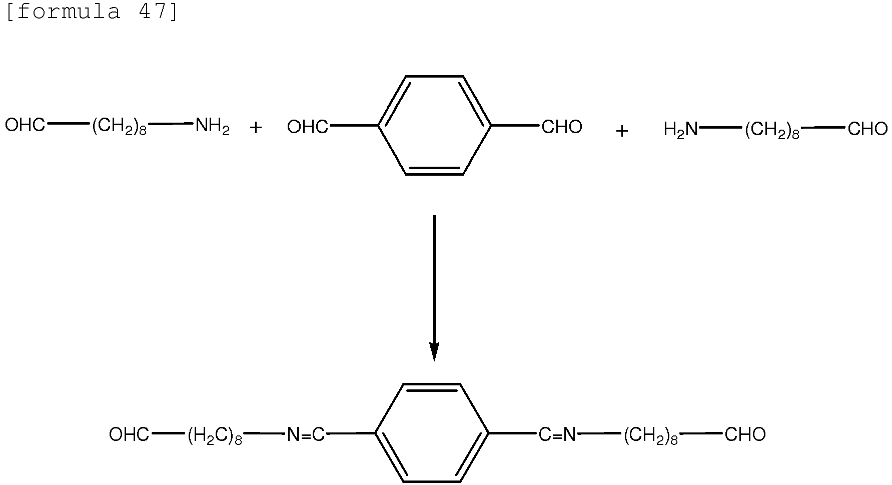

The above-mentioned reaction of one stage can be carried out by adding an excessive amount of 8-aminooctanal to 1,4-diformylbenzene. In the above reaction, the aromatic ring-containing compound, with aldehyde groups being attached to both of the terminals of the molecule, can be obtained; however, in the case when the reaction materials to be used are changed to 1,4-diaminobenzene and 8-aminooctanal, an aromatic ring-containing compound, with amino groups being attached to both of the terminals of the molecule, and with the orientation of the azomethine group being reversed, can be obtained.

Since the amino group and the aldehyde group have high reactivity, the above reaction is allowed to easily progress.

These reactions can be carried out under commonly used known reaction conditions for reacting an amino group and an aldehyde group with each other, and the reaction temperature is normally set in a range of 30 to 120°C and the reaction time is normally set in a range of 2 to 48 hours.

Moreover, examples of the reaction solvent include: an ester-based solvent such as ethyl acetate or butyl acetate, an aromatic solvent such as toluene or xylene, an ether-based solvent such as THF or cyclopentyl methyl ether, a ketone-based solvent such as MEK or cyclopentanone, a proton donor-type aromatic solvent such as m-cresol or phenol (preferably used under an acid catalyzed reaction condition), a halogen-containing solvent such as chloroform, methylene chloride, tetrachloroethane or chlorobenzene, a proton accepting solvent such as NMP, DMF, pyridine or piperidine (preferably used under a base catalyzed reaction condition), and a nitrile-based solvent such as acetonitrile or benzonitrile.

As described above, the aromatic ring-containing compounds for use as the production material of polyazomethine of the present invention are commercially available, or can be easily obtained by allowing those commercial products to react with each other.

### (Specific Examples of Aromatic Ring-Containing Compound)

As specific examples of the aromatic ring-containing compound represented by the above-mentioned formula (III), compounds represented by the following formulas are listed.

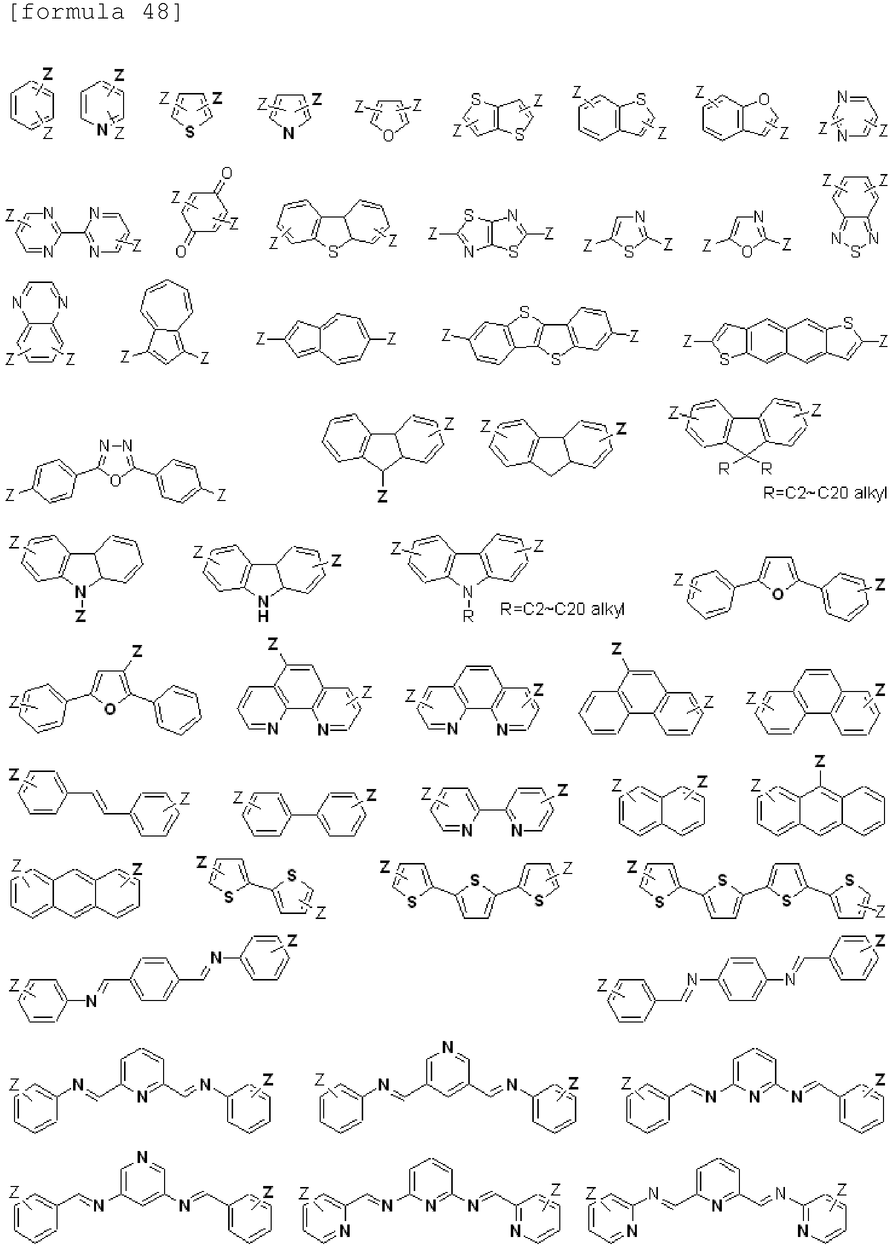

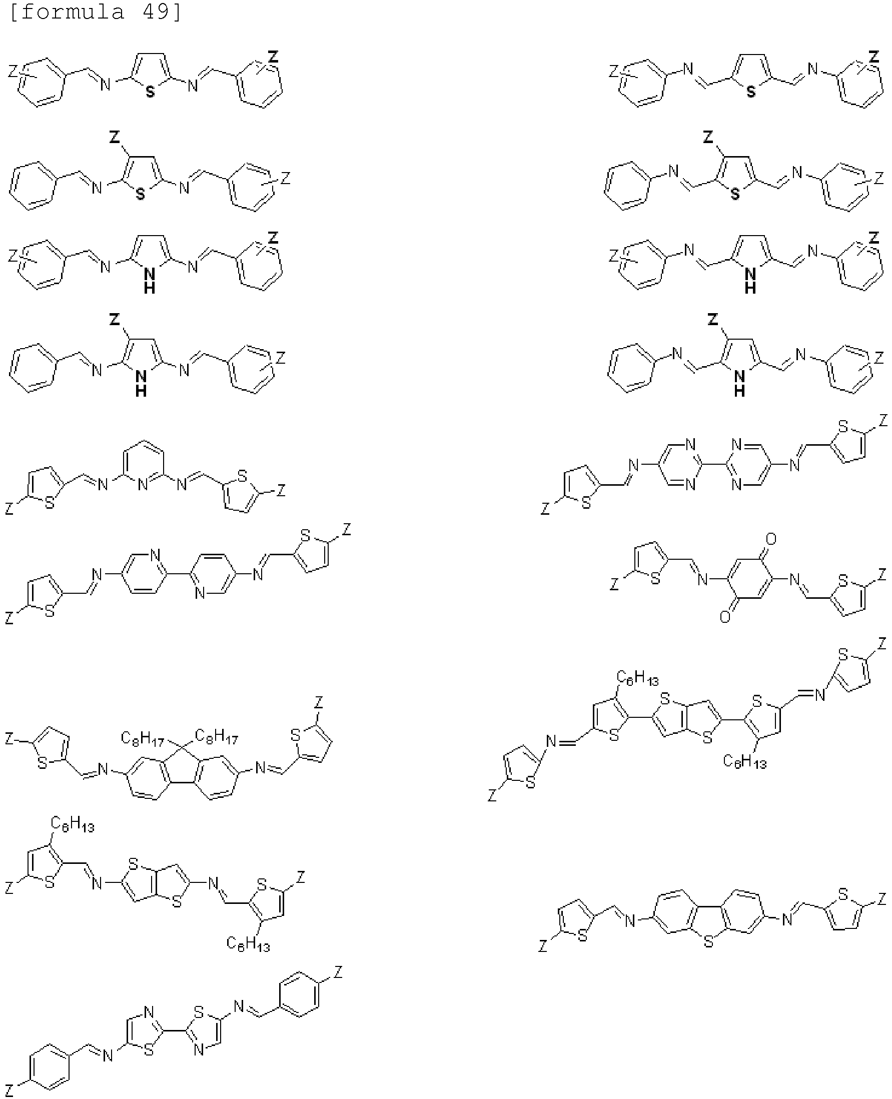

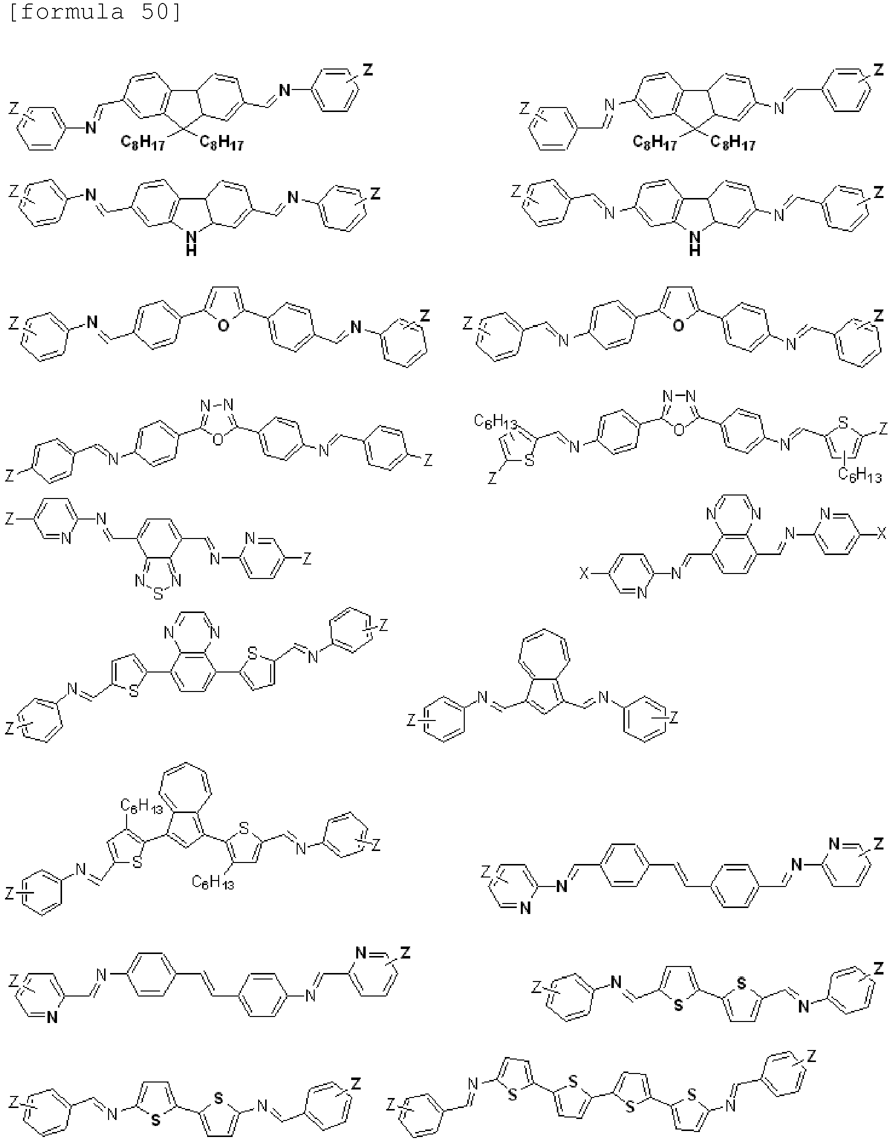

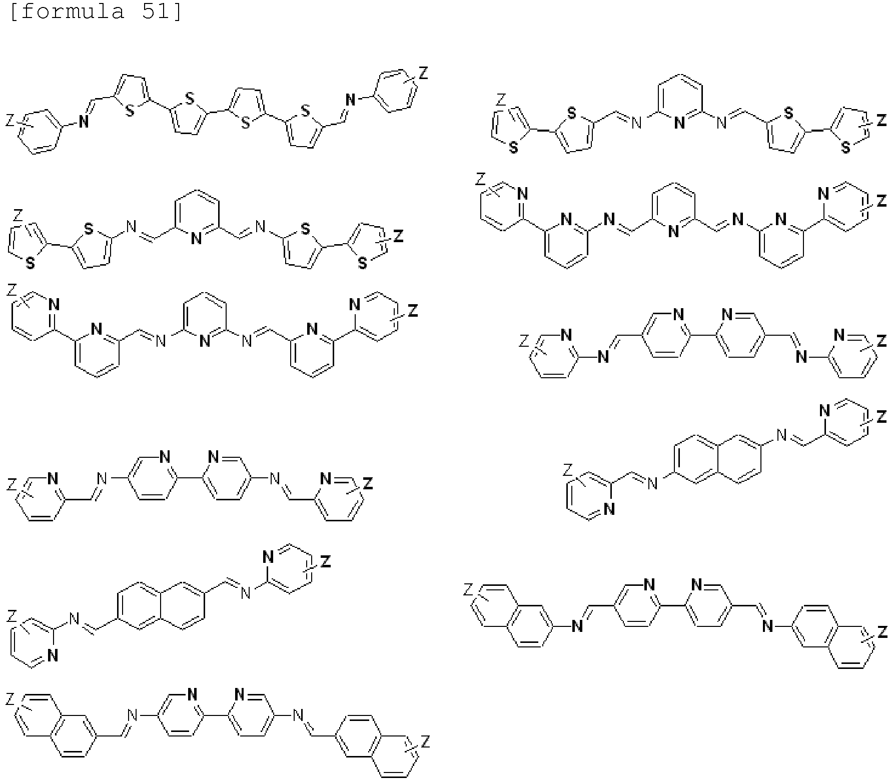

In the above-mentioned formulas, Z represents an aldehyde group or an amino group.

### <Arrangement Sequence of Aromatic Ring-Containing Conjugated Group and Divalent Hydrocarbon Group in Repeating Unit Forming Polyazomethine>

By appropriately selecting the structures of the hydrocarbon compound represented by formula (II) and the aromatic ring-containing compound represented by formula (III) described above, the arrangement sequence of the aromatic ring-containing conjugated group and the divalent hydrocarbon group in the repeating unit forming the polyazomethine of the present invention can be freely controlled.

Additionally, as described earlier, in formula (II), h and m are preferably set to 0, and in formula (III), y and z are preferably set to 0; thus, in the case when such hydrocarbon compound and aromatic ring-containing compound are copolymerized, polyazomethine which has the hydrocarbon group and the aromatic ring-containing conjugated group alternately arranged in the repeating unit can be obtained.

### <Reaction>

In the production method for polyazomethine of the present invention, by copolymerizing the hydrocarbon compound and the aromatic ring-containing compound with each other (the aldehyde group or amino group possessed by the hydrocarbon compound reacts with the amino group or aldehyde group of the aromatic ring-containing compound), the polyazomethine of the present invention which has a repeating unit formed by bonding the aromatic ring-containing group and the divalent hydrocarbon group with each other via an azomethine group is produced.

In the production method for the polyazomethine of the present invention, one kind of each of the hydrocarbon compound and the aromatic ring-containing compound may be used, or a plurality of kinds of either one of them may be used, or a plurality of kinds of both of them may be used.

The reaction temperature in the copolymerizing reaction is normally set in a range of 30 to 120°C and, from the viewpoint of reaction efficiency, is more preferably set in a range of 60 to 100°C.

The reaction time in the copolymerizing reaction is normally set in a range of 2 to 72 hours and, from the viewpoint of reaction efficiency, is more preferably set in a range of 6 to 54 hours.

Moreover, in the above-mentioned reaction, those catalysts used for addition reaction to be catalyzed by a general acid, such as m-cresol, dimethylphenol, phenol, camphor sulfonic acid, naphthol, formic acid, acetic acid, propionic acid, hydrochloric acid and sulfuric acid, may be used, or those bases used for addition reaction to be catalyzed by general bases may also be used as a catalyst in the above-mentioned reaction.

Moreover, examples of the reaction solvent in the above-mentioned reaction include: an ester-based solvent, such as ethyl acetate or butyl acetate; an aromatic solvent, such as toluene or xylene; an ether-based solvent, such as THF or cyclopentyl methyl ether; a ketone-based solvent, such as MEK or cyclopentanone; a proton- donor-type aromatic solvent, such as m-cresol or phenol (preferably applied under an acid-catalyzed reaction condition); a halogen-containing solvent, such as chloroform, methylene chloride , tetrachloroethane or chlorobenzene; a proton-accepting-type solvent, such as NMP, DMF, pyridine or piperidine (preferably applied under a base-catalyzed reaction condition), and a nitrile-based solvent, such as acetonitrile or benzonitrile. Among these, from the view point of reaction efficiency, m-cresol, toluene-m-cresol co-solvent, THF, cyclopentyl methyl ether and cyclopentanone are preferably used.

Since the aldehyde group and the amino group have high reactivity, the copolymerization reaction easily proceeds. Therefore, polyazomethine of the present invention can be easily produced from materials (monomers) that are easily available. Thus, the polyazomethine does not cause such a problem as to be caused by difficulty in industrialization due to unavailability as commercial products of material monomers, which is caused by polyazomethine, disclosed in Non-Patent literature 5, in which an alkyl group, an alkoxy group, or the like is introduced in an aromatic ring, a hetero ring, or an aromatic ring and a hetero ring, in the main chain.

Moreover, since the conventional polyazomethine has a conjugated structure in one molecule, its solubility to a polymerization solvent is lowered as the condensation polymerization proceeds, and it is deposited from the polymerization solvent before being allowed to have a high molecular weight, with the result that its molecular weight does not become higher. That is, since the weight-average molecular weight of the conventional polyazomethine is dependent on the solubility of the conjugated structure (aromatic ring structure in aromatic ring diamine and aromatic ring dialdehyde that are monomers), it has been difficult to control the molecular weight (in particular, providing a high molecular weight).

In contrast, the polyazomethine of the present invention has a one-molecule non-conjugated structure in which a conjugated structure having a low solubility to the solvent and a non-conjugated structure having a high solubility to the solvent are alternately bonded to each other. For this reason, since it is possible to avoid a problem in which the solubility of the azomethine structure to the polymerization solvent is impaired as the condensation polymerization proceeds, adjustments of the weight-average molecular weight can be carried out by adjusting the reaction time and the reaction rate. The reaction rate can be adjusted by adding a quencher or the like so as to capture water formed inside the reaction system as the condensation process proceeds so as to preferentially carry out the reaction for forming a condensate product in the strength (kinds) of an acid or base catalyst, the quantity of catalyst and equilibrium reaction, and adjusting the concentration of monomers to be loaded. In general, a higher molecular-weight providing process can be carried out by using a strong acid or base catalyst, by adding the quencher for use in capturing water, and by making the reaction time longer.

### <Other Processes>

The production method for the polyazomethine of the present invention is characterized by a process in which the above-mentioned hydrocarbon compound and aromatic ring-containing compound are copolymerized with each other.

In the production method for the polyazomethine of the present invention, a process for purifying the polyazomethine obtained by the above-mentioned process may be carried out.

The purification process is divided into a purification process A that is carried out when a polymer is deposited after the completion of the reaction, and a purification process B that is carried out when no deposition is formed.

In the case of the former (purification process A), a reaction solution is filtrated, and a solvent to which the resulting polymer does not have solubility or it has a low solubility (poor solvent) and to which a hydrocarbon compound and an aromatic ring-containing compound that are synthesizing materials for polyazomethine are soluble is used as a washing solvent, and by repeating washing processes several times, its purification process can be carried out.

On the other hand, in the case of the latter (purification process B), to a reaction solution itself, or to a solution obtained after vacuum-drying the reaction solution, a solvent to which polyazomethine does not have solubility or which has a low solubility is added so that polyazomethine is deposited. Thereafter, the solution containing the deposited polyazomethine is filtrated, and a solvent to which the polyazomethine does not have solubility or which has a low solubility (poor solvent) and to which a hydrocarbon compound and an aromatic ring-containing compound that are synthesizing materials for polyazomethine are soluble, is used as a washing solvent. By repeating the washing process of the polyazomethine several times, its purification process can be carried out.

### EXAMPLES

Referring to examples and comparative examples, the following description will discuss the present invention in detail; however, the present invention is not intended to be limited thereby.

### <Synthesis of Material 1>

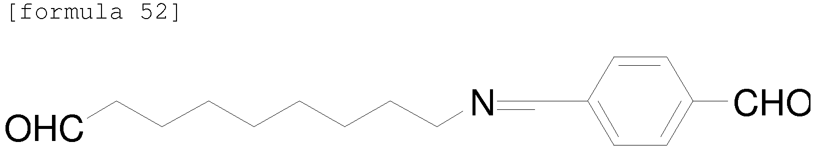

To a nitrogen-substituted schlenk flask of 100 mL were loaded 3.35 g (25.0 mmol) of terephthalaldehyde, 5 g of m-cresol and 30 g of toluene, and the reaction solution was heated to 70°C while being stirred. Thereafter, to the solution was dripped a solution formed by dissolving 1.57 g (10.0 mmol) of 8-aminooctanal in 30 g of toluene in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 2.49 g (yield: 91%) of hydrocarbon compound represented by formula (II) was obtained as a light yellow oil. FAB-MS: m/z=274[M+H]⁺.

### <Synthesis of Material 2>

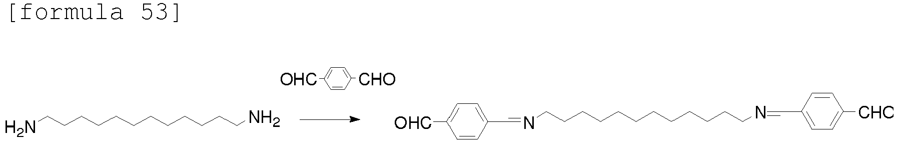

To a nitrogen-substituted schlenk flask of 100 mL were loaded 3.35 g (25.0 mmol) of terephthalaldehyde, 5 g of m-cresol and 30 g of toluene, and the reaction solution was heated to 70°C while being stirred. Thereafter, to the solution was dripped a solution formed by dissolving 2.00 g (10.0 mmol) of 1,12-diaminododecane in 30 g of toluene in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 3.37 g (yield: 78%) of hydrocarbon compound represented by formula (II) was obtained as a light yellow solid. FAB-MS: m/z=433[M+H]⁺.

### <Synthesis of Material 3>

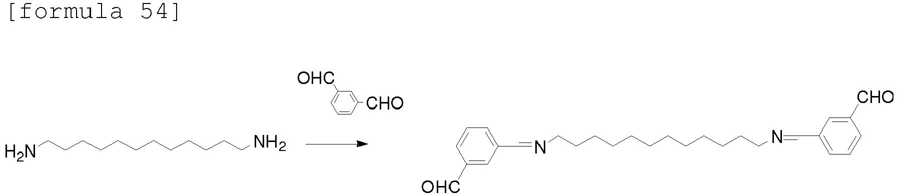

To a nitrogen-substituted schlenk flask of 100 mL were loaded 3.35 g (25.0 mmol) of isophthalaldehyde, 5 g of m-cresol and 30 g of toluene, and the reaction solution was heated to 70°C while being stirred. Thereafter, to the solution was dripped a solution formed by dissolving 2.00 g (10.0 mmol) of 1,12-diaminododecane in 30 g of toluene in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 3.37 g (yield: 78%) of hydrocarbon compound represented by formula (II) was obtained as a light yellow solid. FAB-MS: m/z=433[M+H]⁺.

<Synthesis of Material 4>

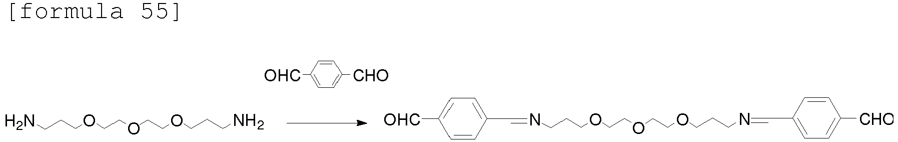

To a nitrogen-substituted schlenk flask of 100 mL were loaded 3.35 g (25.0 mmol) of terephthalaldehyde, 5 g of m-cresol and 30 g of toluene, and the reaction solution was heated to 70°C while being stirred. Thereafter, to the solution was dripped a solution formed by dissolving 1.48 g (10.0 mmol) of 1,2-bis(2-aminoethoxy)ethane in 30 g of toluene in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 3.62 g (yield: 80%) of hydrocarbon compound represented by formula (II) was obtained as a light yellow solid. FAB-MS: m/z=453[M+H]⁺.

### <Synthesis of Material 5>

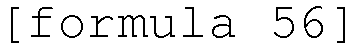

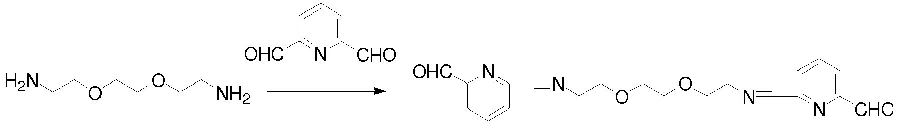

To a nitrogen-substituted schlenk flask of 100 mL were loaded 3.38 g (25.0 mmol) of pyridine-2, 6-dicarbaldehyde, 5 g of m-cresol and 30 g of THF, and the reaction solution was heated to 70°C while being stirred. Thereafter, to the solution was dripped a solution formed by dissolving 1.48 g (10.0 mmol) of 1,2-bis(2-aminoethoxy)ethane in 30 g of THF in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 3.06 g (yield: 80%) of hydrocarbon compound represented by formula (II) was obtained as a light yellow solid. FAB-MS: m/z=383[M+H]⁺.

### <Synthesis of Material 6>

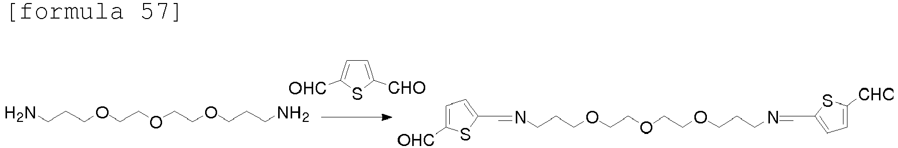

To a nitrogen-substituted schlenk flask of 100 mL were loaded 3.50 g (25.0 mmol) of thiophene-2,5-dicarbaldehyde, 5 g of m-cresol and 30 g of THF, and the reaction solution was heated to 70°C while being stirred. Thereafter, to the solution was dripped a solution formed by dissolving 2.20 g (10.0 mmol) of diethylene glycol bis(2-aminopropyl ether) in 30 g of THF in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 3.50 g (yield: 80%) of hydrocarbon compound represented by formula (II) was obtained as a light yellow solid. FAB-MS: m/z=465[M+H]⁺.

### <Synthesis of Material 7>

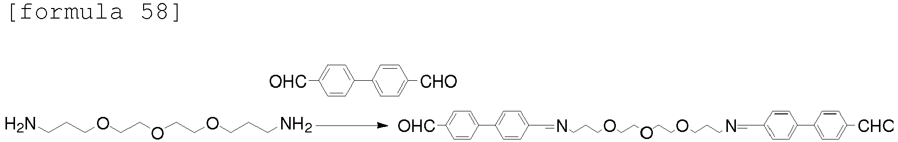

To a nitrogen-substituted schlenk flask of 100 mL were loaded 5.26 g (25.0 mmol) of 4,4'-biphenyl dicarboxyaldehyde, 5 g of m-cresol and 30 g of THF, and the reaction solution was heated to 70°C while being stirred. Thereafter, to the solution was dripped a solution formed by dissolving 2.20 g (10.0 mmol) of diethylene glycol bis(2-aminopropyl ether) in 30 g of THF in 3 hours. Then, after stirring the solution for 3 hours, the reaction was completed.

After removing a volatile solvent in the reaction solution by evaporation, the condensed solution was vacuum-dried, and washed with hexane and dimethyl ether. Thus, 4.78 g (yield: 79%) of hydrocarbon compound represented by formula (II) was obtained as a light yellow solid. FAB-MS: m/z=605[M+H]⁺.

### <Synthesis of Material 8>

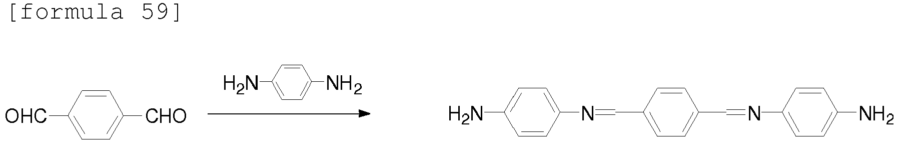

To a nitrogen-substituted schlenk flask of 100 mL were loaded 2. 70 g (25. 0 mmol) of 1, 4-phenylenediamine, 5 g of m-cresol and 30 g of toluene, and the reaction solution was heated to 70°C while being stirred. Thereafter, to the solution was dripped a solution formed by dissolving 1.34 g (10.0 mmol) of terephthalaldehyde in 30 g of toluene in 3 hours. Then, after stirring the solution for 3 hours, the reaction was completed.

After removing a volatile solvent in the reaction solution by evaporation, the condensed solution was vacuum-dried, and washed with hexane, dimethyl ether and acetonitrile. Thus, 2.52 g (yield: 80%) of aromatic ring-containing compound represented by formula (III) was obtained as a light yellow solid. FAB-MS: m/z=315[M+H]⁺.

### <Synthesis of Material 9>

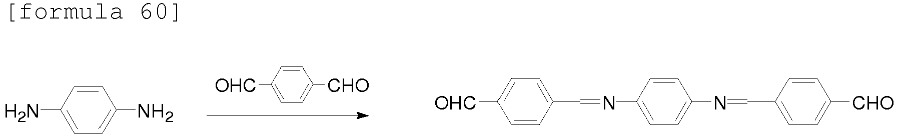

To a nitrogen-substituted schlenk flask of 100 mL were loaded 3.35 g (25.0 mmol) of terephthalaldehyde, 5 g of m-cresol and 30 g of toluene, and the reaction solution was heated to 70°C while being stirred. Thereafter, to the solution was dripped a solution formed by dissolving 1.08 g (10.0 mmol) of 1,4-phenylenediamine in 30 g of toluene in 3 hours. Then, after stirring the solution for 3 hours, the reaction was completed.

After removing a volatile solvent in the reaction solution by evaporation, the condensed solution was vacuum-dried, and washed with hexane, dimethyl ether and acetonitrile. Thus, 2.52 g (yield: 80%) of aromatic ring-containing compound represented by formula (III) was obtained as a light yellow solid. FAB-MS: m/z=315[M+H]⁺.

### <Synthesis of Material 10>

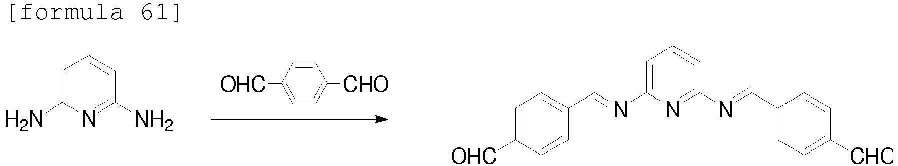

To a nitrogen-substituted schlenk flask of 100 mL were loaded 3.35 g (25.0 mmol) of terephthalaldehyde, 5 g of m-cresol and 30 g of toluene, and the reaction solution was heated to 70°C while being stirred. Thereafter, to the solution was dripped a solution formed by dissolving 1.09 g (10.0 mmol) of 2,6-diaminopyridine in 30 g of toluene in 3 hours. Then, after stirring the solution for 3 hours, the reaction was completed.

After removing a volatile solvent in the reaction solution by evaporation, the condensed solution was vacuum-dried, and washed with hexane, dimethyl ether and acetonitrile. Thus, 2.60 g (yield: 75%) of aromatic ring-containing compound represented by formula (III) was obtained as a light yellow solid. FAB-MS:

m/z=342 [M+H]⁺.

### <Synthesis of Material 11>

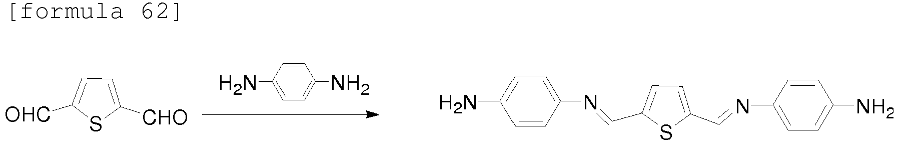

To a nitrogen-substituted schlenk flask of 100 mL were loaded 2. 70 g (25. 0 mmol) of 1, 4-phenylenediamine, 5 g of m-cresol and 30 g of toluene, and the reaction solution was heated to 70°C while being stirred. Thereafter, to the solution was dripped a solution formed by dissolving 1.40 g (10.0 mmol) of thiophene-2, 5-dicarbaldehyde in 30 g of toluene in 3 hours. Then, after stirring the solution for 3 hours, the reaction was completed.

After removing a volatile solvent in the reaction solution by evaporation, the condensed solution was vacuum-dried, and washed with hexane, dimethyl ether and acetonitrile. Thus, 2.40 g (yield: 75%) of aromatic ring-containing compound represented by formula (III) was obtained as a light yellow solid. FAB-MS: m/z=321 [M+H]⁺.

### [Example 1]

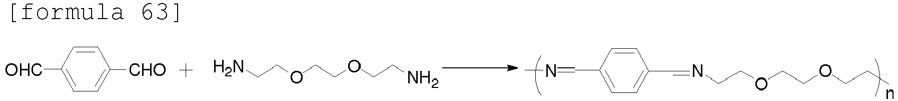

To a nitrogen-substituted schlenk flask of 100 mL were loaded 1.08 g (10.0 mmol) of terephthalaldehyde, 1.48 g (10.0 mmol) of 1,2-bis(2-aminoethoxy)ethane and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.05 g (yield: 78%) of the polyazomethine of the present invention was obtained as a light yellow solid.

With respect to the resultant polyazomethine, by using THF as an eluent, measurements were carried out according to gel permeation chromatography (GPC) so as to find the weight-average molecular weight (Mw) calculated for standard polystyrene. As a result, the weight-average molecular weight of the polyazomethine was Mw = 200,000. In this case, the measuring conditions of GPC were shown below, and the same is true for the following description.

Name of device: HLC-8120 (made by TOSOH CORPORATION)
Column: GF-1G7B + GF-510HQ (Asahipak (registered trademark), made by Showa Denko K.K.)
Reference substance: polystyrene
Sample concentration: 1.0 mg/ml
Eluent: THF
Flow rate: 0.6 ml/min
Column temperature: 40°C
Detector: UV 254 nm

### [Example 2]

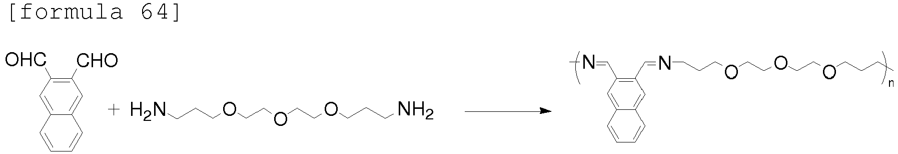

To a nitrogen-substituted schlenk flask of 100 mL were loaded 1.08 g (10.0 mmol) of terephthalaldehyde, 2.20 g (10.0 mmol) of diethylene glycol bis (2-aminopropyl ether) and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.62 g (yield: 80%) of the polyazomethine of the present invention was obtained as a light yellow solid. The resultant polyazomethine had Mw = 120,000.

### [Example 3]

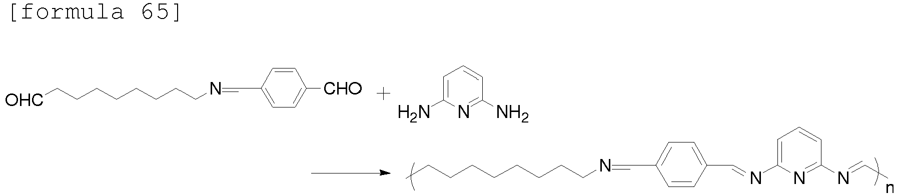

To a nitrogen-substituted schlenk flask of 100 mL were loaded 2.73 g (10.0 mmol) of material 1 obtained by synthesis, 1.09 g (10.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.62 g (yield: 80%) of the polyazomethine of the present invention was obtained as a light red solid. The resultant polyazomethine had Mw = 35,000.

### [Example 4]

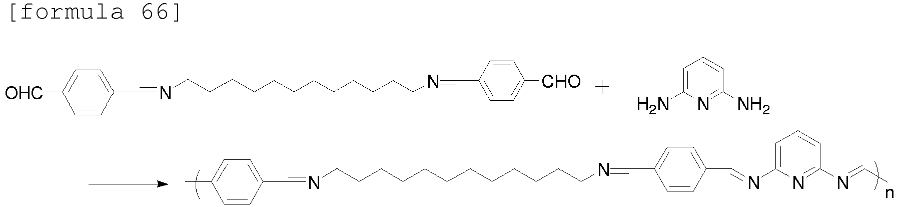

To a nitrogen-substituted schlenk flask of 100 mL were loaded 4.32 g (10.0 mmol) of material 2 obtained by synthesis, 1.09 g (10.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.32 g (yield: 80%) of the polyazomethine of the present invention was obtained as a light red solid. The resultant polyazomethine had Mw = 32,000.

### [Example 5]

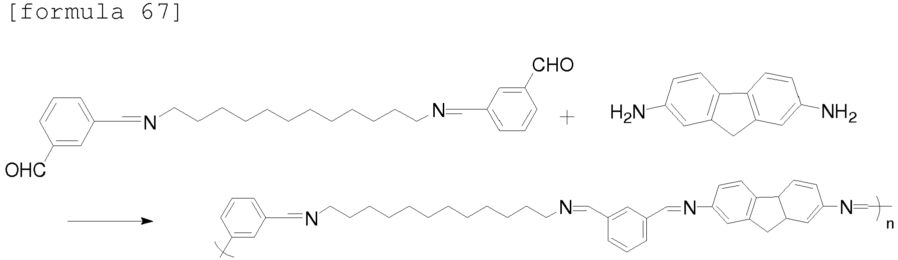

To a nitrogen-substituted schlenk flask of 100 mL were loaded 4.32 g (10.0 mmol) of material 3 obtained by synthesis, 1.96 g (10.0 mmol) of 2,7-diaminofluorene and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 5.02 g (yield: 80%) of the polyazomethine of the present invention was obtained as a light red solid. The resultant polyazomethine had Mw = 6,000.

### [Example 6]

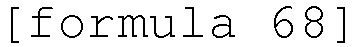

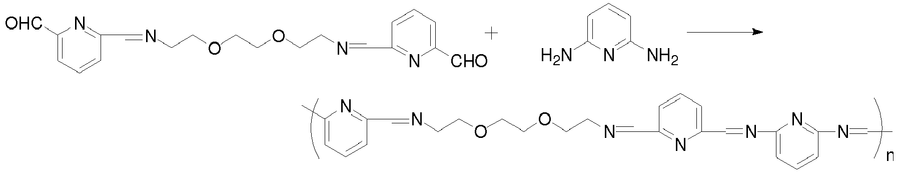

To a nitrogen-substituted schlenk flask of 100 mL were loaded 3.82 g (10.0 mmol) of material 5 obtained by synthesis, 1.09 g (10.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.03 g (yield: 81%) of the polyazomethine of the present invention was obtained as a light red solid. The resultant polyazomethine had Mw = 32,000.

### [Example 7]

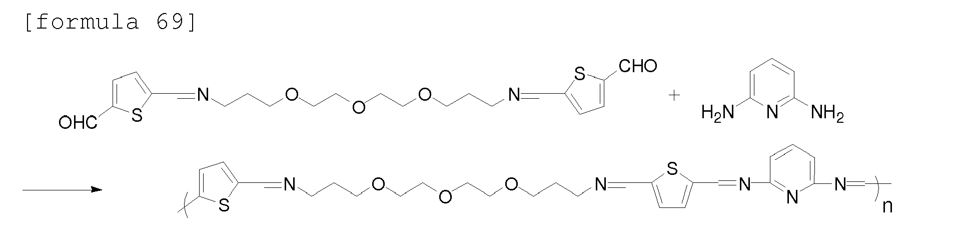

To a nitrogen-substituted schlenk flask of 100 mL were loaded 4.65 g (10.0 mmol) of material 6 obtained by synthesis, 1.09 g (10.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.59 g (yield: 81%) of the polyazomethine of the present invention was obtained as a light red solid. The resultant polyazomethine had Mw = 29,000.

### [Example 8]

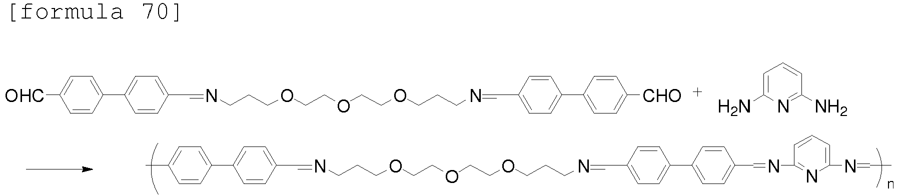

To a nitrogen-substituted schlenk flask of 100 mL were loaded 6.04 g (10.0 mmol) of material 7 obtained by synthesis, 1.09 g (10.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 5.70 g (yield: 81%) of the polyazomethine of the present invention was obtained as a brownish yellow solid. The resultant polyazomethine had Mw = 41,000.

### [Example 9]

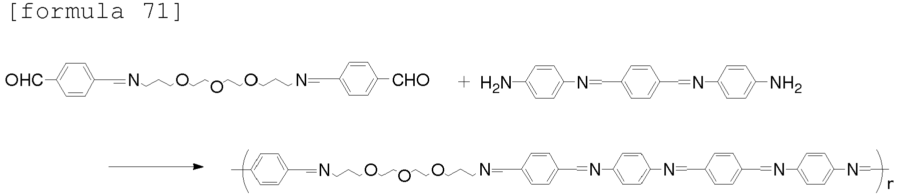

To a nitrogen-substituted schlenk flask of 100 mL were loaded 4.52 g (10.0 mmol) of material 8 and 3.14 g (10.0 mmol) of material 4, each obtained by synthesis, as well as 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 6.13 g (yield: 80%) of the polyazomethine of the present invention was obtained as a brownish yellow solid. The resultant polyazomethine had Mw = 63,000.

### [Example 10]

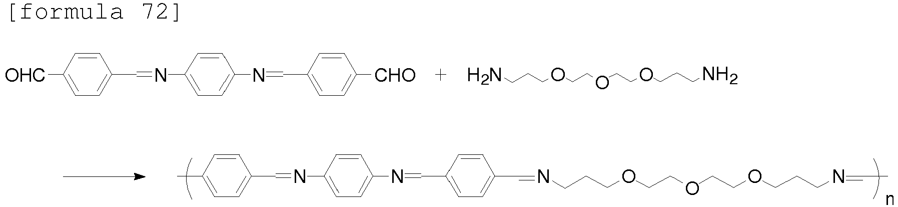

To a nitrogen-substituted schlenk flask of 100 mL were loaded 3.40 g (10.0 mmol) of material 9 obtained by synthesis, 2.20 g (10.0 mmol) of diethylene glycol bis(2-aminopropyl ether) and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.48 g (yield: 80%) of the polyazomethine of the present invention was obtained as a brownish yellow solid. The resultant polyazomethine had Mw = 150,000.

### [Example 11]

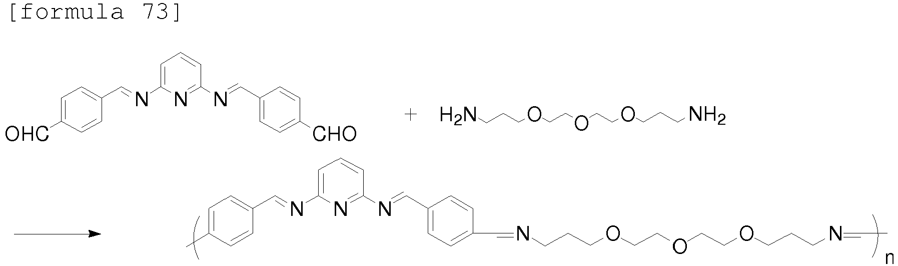

To a nitrogen-substituted schlenk flask of 100 mL were loaded 3.41 g (10.0 mmol) of material 10 obtained by synthesis, 2.20 g (10.0 mmol) of diethylene glycol bis(2-aminopropyl ether) and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.49 g (yield: 80%) of the polyazomethine of the present invention was obtained as a reddish brown solid. The resultant polyazomethine had Mw = 29,000.

### [Example 12]

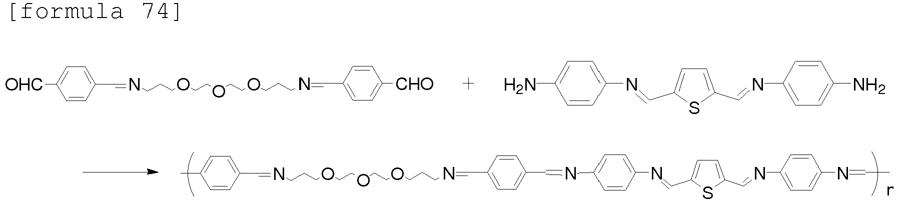

To a nitrogen-substituted schlenk flask of 100 mL were loaded 4.52 g (10.0 mmol) of material 4 and 3.20 g (10.0 mmol) of material 11, each obtained by synthesis, as well as 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 6.18 g (yield: 80%) of the polyazomethine of the present invention was obtained as a brownish yellow solid. The resultant polyazomethine had Mw = 43,000.

### [Example 13]

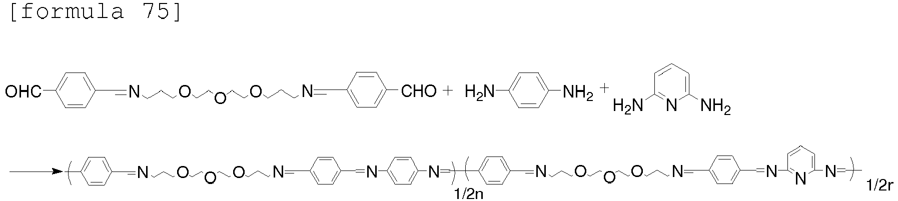

To a nitrogen-substituted schlenk flask of 100 mL were loaded 4.52 g (10.0 mmol) of material 4 obtained by synthesis, 0.54 g (5.0 mmol) of 1,4-phenylenediamine, 0.55 g (5.0 mmol) of 2,6-diaminopyridine and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 4.21 g (yield: 75%) of the polyazomethine of the present invention was obtained as a brownish yellow solid. The resultant polyazomethine had Mw = 143,000.

### [Comparative Example 1]

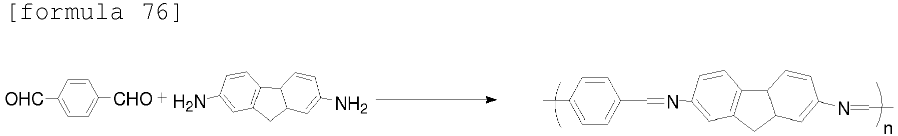

To a nitrogen-substituted schlenk flask of 100 mL were loaded 1.34 g (10.0 mmol) of terephthalaldehyde, 1.98 g (10.0 mmol) of 2,7-diaminofluorene, and 20 g of m-cresol, and the reaction solution was heated to 70°C while being stirred. Thereafter, the reaction solution was stirred for 48 hours, and the reaction was completed.

After the reaction solution had been filtrated under a reduced pressure, the resulting matter was washed with hot hexane, dimethyl ether and acetonitrile. Thus, 2.66 g (yield: 80%) of polyazomethine was obtained as a yellow solid. Since the resultant polyazomethine was insoluble to THF, it was impossible to measure the weight-average molecular weight thereof.

### [Comparative Example 2]

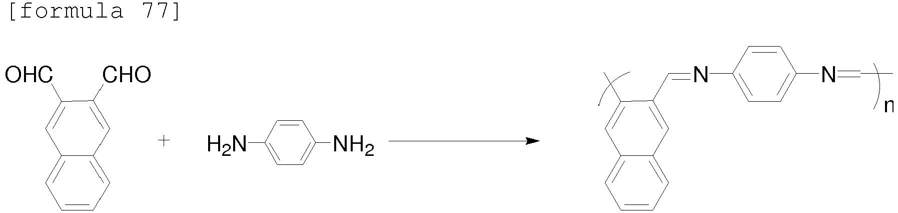

To a nitrogen-substituted schlenk flask of 100 mL were loaded 1.84 g (10.0 mmol) of naphthalene-2,3-dicarbaldehyde, 1.08 g (10.0 mmol) of 1,4-phenylenediamine, and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.48 g (yield: 85%) of polyazomethine was obtained as a yellow solid. Since the resultant polyazomethine was insoluble to THF, it was impossible to measure the weight-average molecular weight thereof.

### [Comparative Example 3]

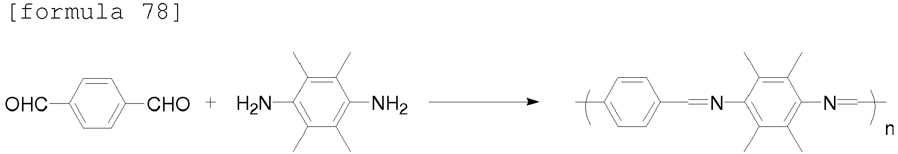

To a nitrogen-substituted schlenk flask of 100 mL were loaded 1.08 g (10. 0 mmol) of terephthalaldehyde, 1.64 g (10.0 mmol) of 2,3,5,6-tetramethyl-1,4-phenylenediamine, and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.18 g (yield: 80%) of polyazomethine was obtained as a yellow solid. Since the resultant polyazomethine was insoluble to THF, it was impossible to measure the weight-average molecular weight thereof.

### [Comparative Example 4]

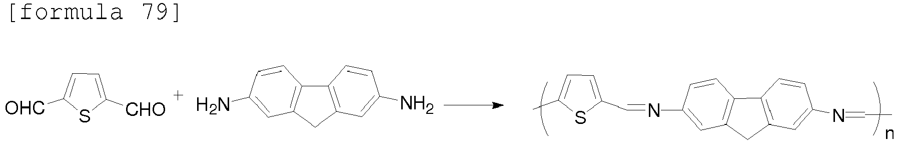

To a nitrogen-substituted schlenk flask of 100 mL were loaded 1.40 g (10.0 mmol) of thiophene-2,5-dicarbaldehyde, 1.96 g (10.0 mmol) of 2,7-diaminofluorene, and 20 g of m-cresol, and the reaction solution was heated to 70°C while being stirred. Thereafter, the reaction solution was stirred for 48 hours, and the reaction was completed.

After vacuum-drying the reaction solution, the resulting matter was washed with hot hexane, dimethyl ether and acetonitrile. Thus, 2.86 g (yield: 85%) of polyazomethine was obtained as a yellow solid. Since the resultant polyazomethine was insoluble to THF, it was impossible to measure the weight-average molecular weight thereof.

### <Evaluation of Solubility>

The solubility to each of solvents shown in the following Table 1 of each of polyazomethines obtained in examples 1 to 13 and comparative examples 1 to 4 was evaluated.

**[Table 1-1]**

| | Sample | | | | | | | | | | |
|---|---|---|---|---|---|---|---|---|---|---|---|
| Organic solvent | Ex. 1 | Ex. 2 | Ex. 3 | Ex. 4 | Ex. 5 | Ex. 6 | Ex. 7 | Ex. 8 | Ex. 9 | Ex. 10 | Ex. 11 |
| Methanol | A | A | A | A | B | A | A | A | B | B | A |
| Ethanol | A | B | A | A | C | A | A | A | B | B | A |
| Acetonitrile | B | B | B | B | C | B | B | B | C | C | B |
| Acetone | B | B | B | B | C | B | B | C | C | C | B |
| IPA | A | B | A | A | C | A | A | B | C | C | A |
| THF | A | A | A | A | A | A | A | A | A | A | A |
| MEK | A | A | A | A | B | A | A | B | B | A | A |
| Toluene | A | A | A | A | B | A | A | A | A | A | A |
| PGM | A | A | A | A | A | A | A | A | B | A | A |
| Methyl lactate | A | A | A | A | A | A | A | A | A | A | A |

**[Table 1-2]**

| | Sample | | | | | |
|---|---|---|---|---|---|---|
| Organic solvent | Ex. 12 | Ex. 13 | Comparative example 1 | Comparative example 2 | Comparative example 3 | Comparative example 4 |
| Methanol | A | A | C | C | C | C |
| Ethanol | A | A | C | C | C | C |
| Acetonitrile | C | C | C | C | C | C |
| Acetone | C | C | C | C | C | C |
| IPA | C | C | C | C | C | C |
| THF | A | A | C | C | C | C |
| MEK | B | A | C | C | C | C |
| Toluene | B | A | C | C | C | C |
| PGM | A | A | C | C | C | C |
| Methyl lactate | A | A | C | C | C | C |

| | | | | | | |
|---|---|---|---|---|---|---|
| A: Soluble at room temperature (25°C) (0.1 g or more dissolved in 100 g of solvent), B: Soluble when heated (less than 0. 1 g dissolved in 100 g of solvent at room temperature; however, become soluble when heated to a boiling point of each of various solvents), C: Insoluble (less than 0.1 g dissolved in 100 g of solvent even when heated). IPA: Isopropanol, THF: Tetrahydrofuran, MEK: Methyl ethyl ketone, PGM: Propylene glycol monomethyl ether | | | | | | |

Table 1 shows that the polyazomethine of the present invention, which is provided with a hydrocarbon group having a flexible structure and an aromatic ring-containing conjugated group having a rigid structure, is dissolved in at least one solvent selected from the group consisting of methanol, ethanol, acetonitrile, acetone, IPA, THF, MEK, toluene, PGM and methyl lactate, while polyazomethine formed only by the aromatic ring-containing conjugated group having a rigid structure doesn't exert any solubility to the above-mentioned solvents.

### [Example 14] Confirmation of Acid-Base Interaction between Polyazomethine Having Coordinating Ability and Lewis Acid

With respect to two samples prepared by dissolving polyazomethine obtained in example 4 in THF and 5%-formic acid THF solution, ultraviolet-visible ray absorption spectra were measured, and Fig. 1 shows the results thereof.

As clearly shown by Fig. 1, in comparison with the THF single solvent, the 5%-formic acid THF solution revealed longer wavelength shift of an absorption maximum in the longer wavelength region derived from the formation of an acid-base complex between polyazomethine and formic acid.

## Claims

1. A polyazomethine comprising:
a divalent aromatic ring-containing conjugated group in which an azomethine group and a divalent aromatic group that may have a substituent are alternately bonded to and conjugated with each other; and
a divalent hydrocarbon group that may have an oxygen atom, a sulfur atom or a cycloalkylene group, and is not conjugated with the azomethine group,
wherein the aromatic ring-containing conjugated group and the hydrocarbon group are bonded to each other through azomethine group to form a repeating unit.

2. The polyazomethine according to Claim 1, wherein the polyazomethine has a repeating unit represented by the following formula (I): 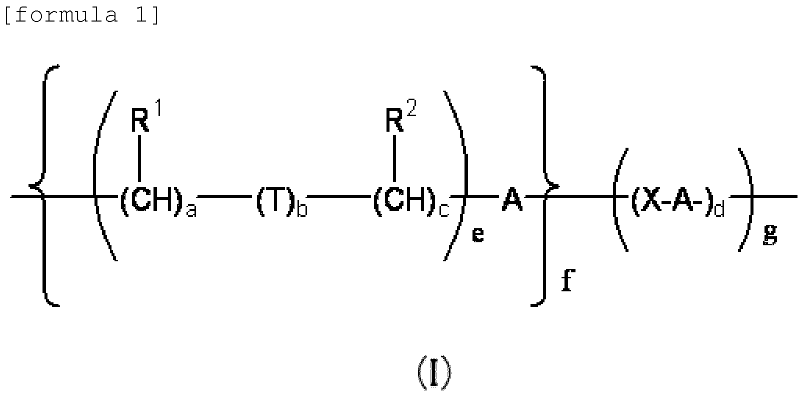 (wherein, each of R¹ and R² is a hydrogen atom, an alkyl group having 1 to 20 carbon atoms, a halogen atom, or a carboxyl group, independently;
A represents an azomethine group;
X represents a divalent aromatic group, which may have a substituent;
T represents a divalent group having an oxygen atom, a sulfur atom, or a cycloalkylene group;
b is 0 or 1;
each of a and c is an integer of 0 to 12 independently (in this case, when T is an oxygen atom or a sulfur atom, both of a and c are 1 or more);
d is an integer of 1 to 10;
e is an integer of 1 to 10;
each of f and g is an integer of 1 to 800 independently;
in the above-mentioned repeating unit, each of a hydrocarbon group represented by {((CHR¹)ₐ - (T)_{b}- (CHR²) _{c})ₑ-A-} and an aromatic ring-containing conjugated group represented by ((X-A)_{d}) are aligned in an arbitrary order,
when a is 2 or more, plural R¹'s may be the same or different,
when c is 2 or more, plural R²'s may be the same or different,
when d is 2 or more, plural X's may be the same or different,
when e is 2 or more, plural ((CHR¹)ₐ - (T)_{b}- (CHR²) _{c})'s may be the same or different,,
when f is 2 or more, a plurality of the hydrocarbon groups may be the same or different,
when g is 2 or more, a plurality of the aromatic ring-containing conjugated groups may be the same or different from each other, and
the number of carbon atoms in the hydrocarbon group is 3 to 43).

3. The polyazomethine according to Claim 1 or 2, wherein the polyazomethine has a weight-average molecular weight in a range of 2,000 to 2,000,000.

4. The polyazomethine according to any one of Claims 1 to 3, wherein the polyazomethine has a solubility of 0.1 g or more at 25°C with respect to 100 g of any one of solvents or cosolvents of two or more kinds selected from the following group: cresol, toluene, THF, cyclopentyl methyl ether, acetone, MEK, MIBK, cyclopentanone, chloroform, dichloromethane, carbon tetrachloride, chlorobezene, carbon disulfide, ethyl acetate, butyl acetate, methyl lactate, methanol, ethanol, isopropyl alcohol, benzyl alcohol, n-butanol, t-butanol, pentyl alcohol, ethylene glycol, propylene glycol, propylene glycol monomethyl ether, pyridine, NMP, sulfuric acid, formic acid, acetic acid, hydrochloric acid, lactic acid, triethylamine and dibutylamine.

5. The polyazomethine according to any one of Claims 1 to 4, wherein the divalent aromatic group is at least one kind of a group selected from the group consisting of groups represented by the following formulas: 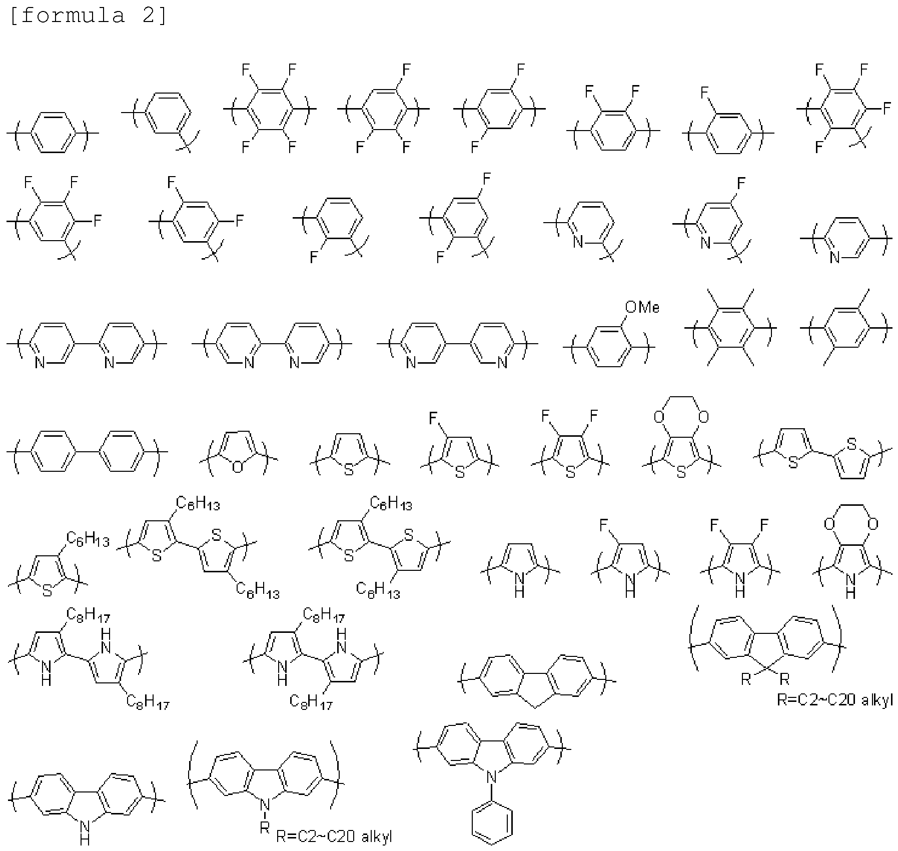 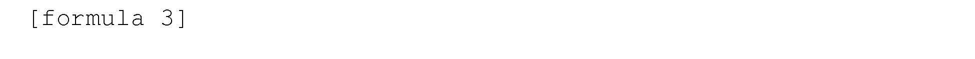 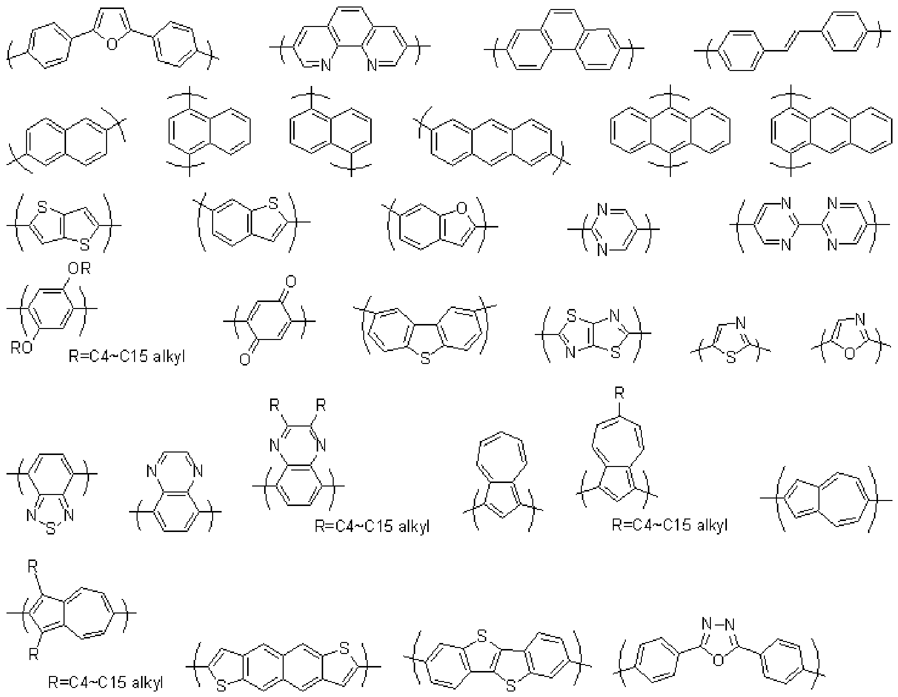 (wherein, a portion crossed by each parenthesis represents a bonding hand).

6. The polyazomethine according to any one of Claims 1 to 5, wherein, with respect to a p-n junction element formed by using the polyazomethine as a forming material for a P-type semiconductor layer or an N-type semiconductor layer, the polyazomethine allows a voltage in a range of -5V to +5V to be applied thereto, with a positive electrode terminal being connected to an electrode of the P-type semiconductor side and with a negative electrode terminal being connected to an electrode of the N-type semiconductor side, so that a ratio of an electric energy in a forward direction/an electric energy in a reverse direction > 1.0 is satisfied.

7. A method for producing the polyazomethine according to Claim 1 comprising the step of: copolymerizing a hydrocarbon compound represented by the following formula (II) with an aromatic ring-containing compound represented by the following formula (III) : 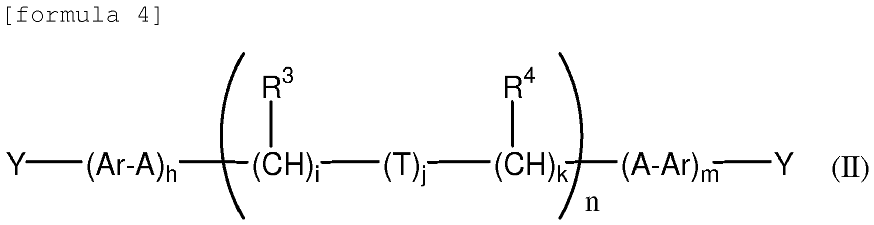 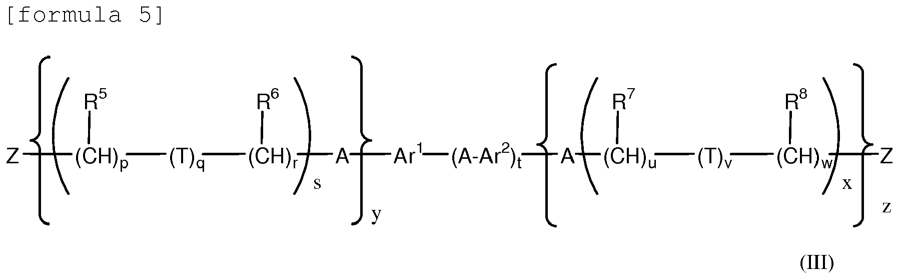 (in the above formula (II), both of two Y's are aldehyde groups or amino groups;
A represents an azomethine group;
each of two Ar's is a divalent aromatic group that may have a substituent, independently;
h and m are 0 or 1, independently;
each of R³ and R⁴ is a hydrogen atom, an alkyl group having 1 to 20 carbon atoms, a halogen atom, or a carboxyl group, independently;
T represents a divalent group having an oxygen atom, a sulfur atom or a cycloalkylene group;
j is 0 or 1;
i and k are integers of 0 to 12 independently (in the case when T is an oxygen atom or a sulfur atom, both of i and k are 1 or more);
n is an integer of 1 to 10;
when i is 2 or more, plural R³'s may be the same or different;
when k is 2 or more, plural R⁴'s may be the same or different;
when n is 2 or more, plural (-(CHR³)ᵢ - (T)ⱼ- (CHR⁴)ₖ-)'s may be the same or different;
the number of carbon atoms in the structure represented by (-(CHR³)ᵢ - (T)ⱼ- (CHR⁴)ₖ-)ₙ is set to 2 to 42; and
in the above formula (III), when Y in the formula (II) is an aldehyde group, each of the two Z's represents an amino group, and when the Y is an amino group, each of the two Z's represents an aldehyde group;
Ar¹ represents a divalent aromatic group, which may have a substituent;
Ar² represents a divalent aromatic group, which may have a substituent;
A is an azomethine group;
t is an integer of 0 to 8;
when t is 2 or more, plural Ar²'s may be the same or different;
each of R⁵ to R⁸ represents a hydrogen atom, an alkyl group having 1 to 20 carbon atoms, a halogen atom, or a carboxyl group, independently;
each of the two T's represents a divalent group having an oxygen atom, a sulfur atom, or a cycloalkylene group independently;
each of q and v is 0 or 1 independently;
each of p and r, as well as each of u and w, is an integer of 0 to 12 independently (in the case when T is an oxygen atom or a sulfur atom, each of p and r, as well as each of u and w, is 1 or more);
each of s and x is an integer of 1 to 10, independently;
when p is 2 or more, plural R⁵'s may be the same or different;
when r is 2 or more, plural R⁶'s may be the same or different;
when u is 2 or more, plural R⁷'s may be the same or different;
when w is 2 or more, plural R⁸'s may be the same or different;
when s is 2 or more, plural (-(CHR⁵)ₚ - (T)_{q}- (CHR⁶)ᵣ-)'s may be the same or different;
when x is 2 or more, plural (-(CHR⁷)ᵤ - (T)ᵥ- (CHR⁸)_{w}-)'s may be the same or different;
each of y and z is 0 or 1, independently; and
each a structure represented by (-(CHR⁵)ₚ - (T)_{q}- (CHR⁶)ᵣ-)ₛ and a structure represented by (-(CHR⁷)ᵤ - (T)ᵥ- (CHR⁸)_{w}-)ₓ has 2 to 42 carbon atoms).

8. The method for producing the polyazomethine according to Claim 7, wherein the aromatic ring-containing compound is at least one kind of compound selected from the group consisting of compounds represented by the following formulas: 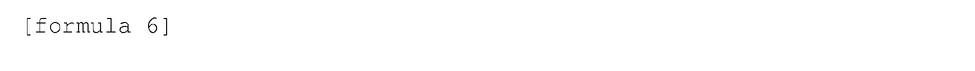 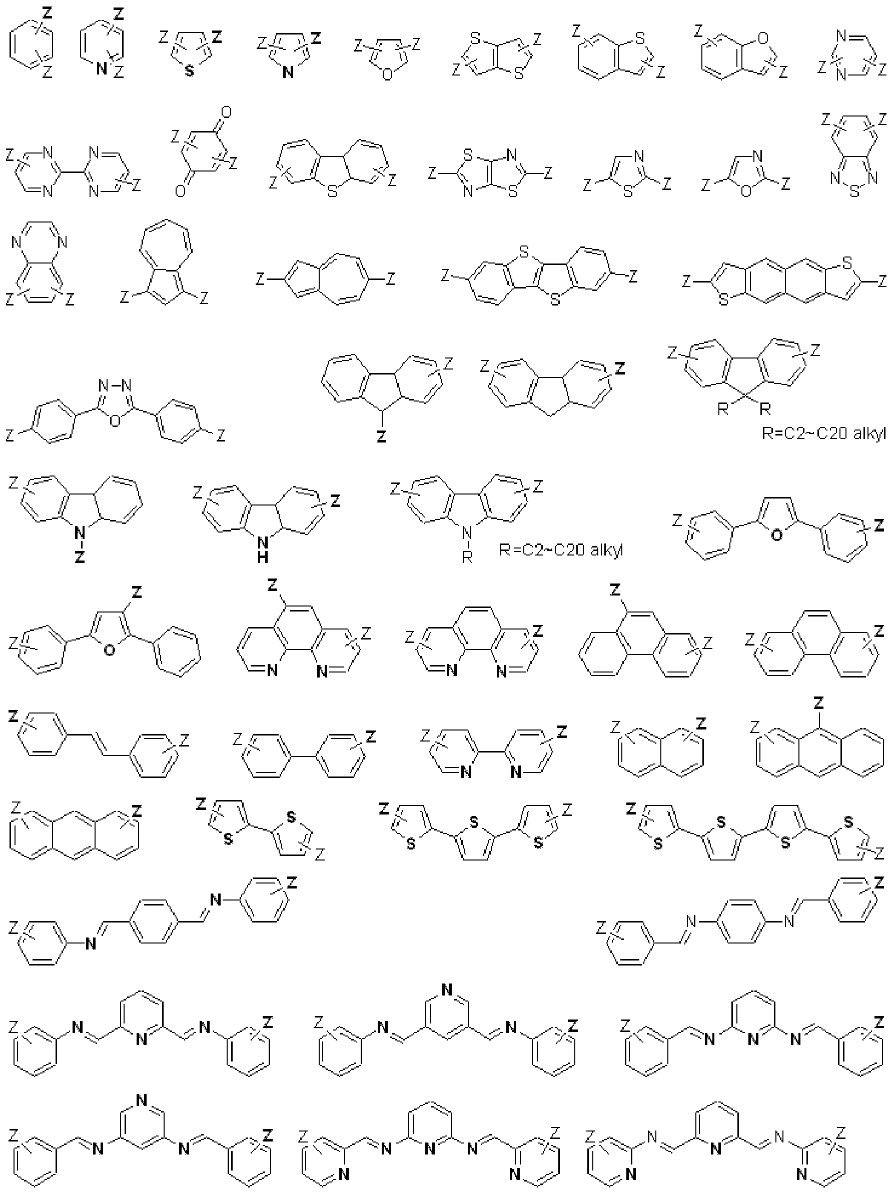 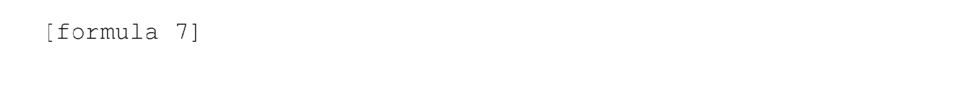 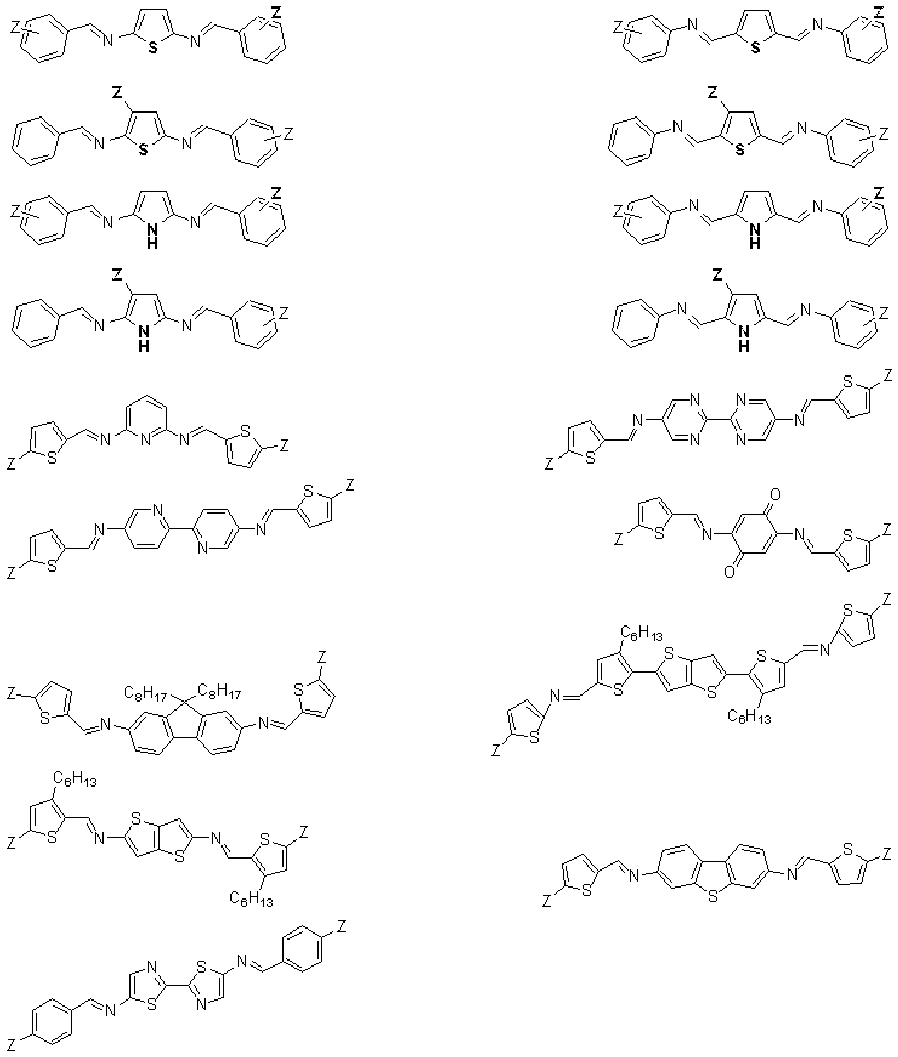 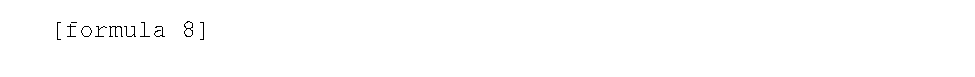 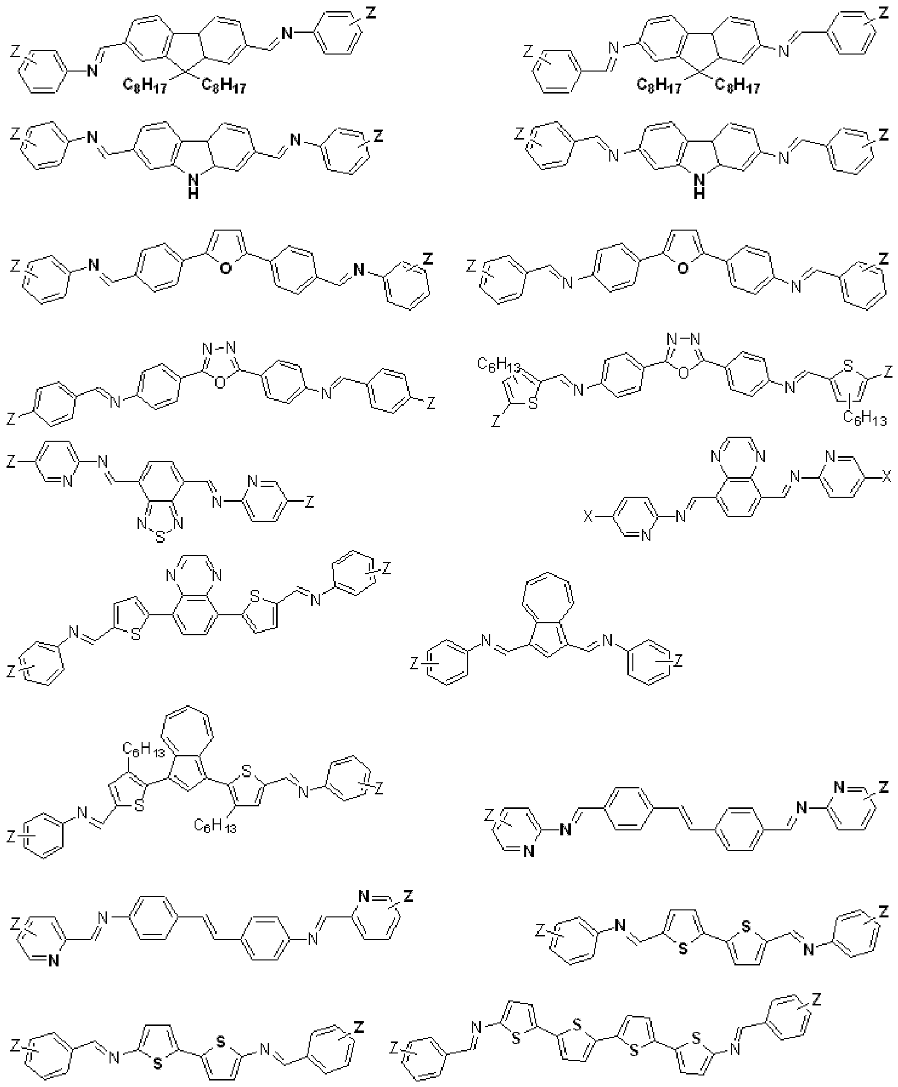 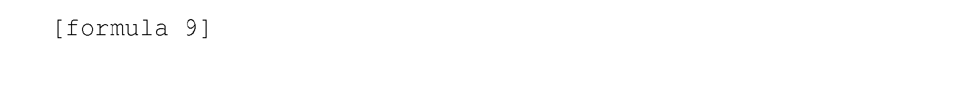 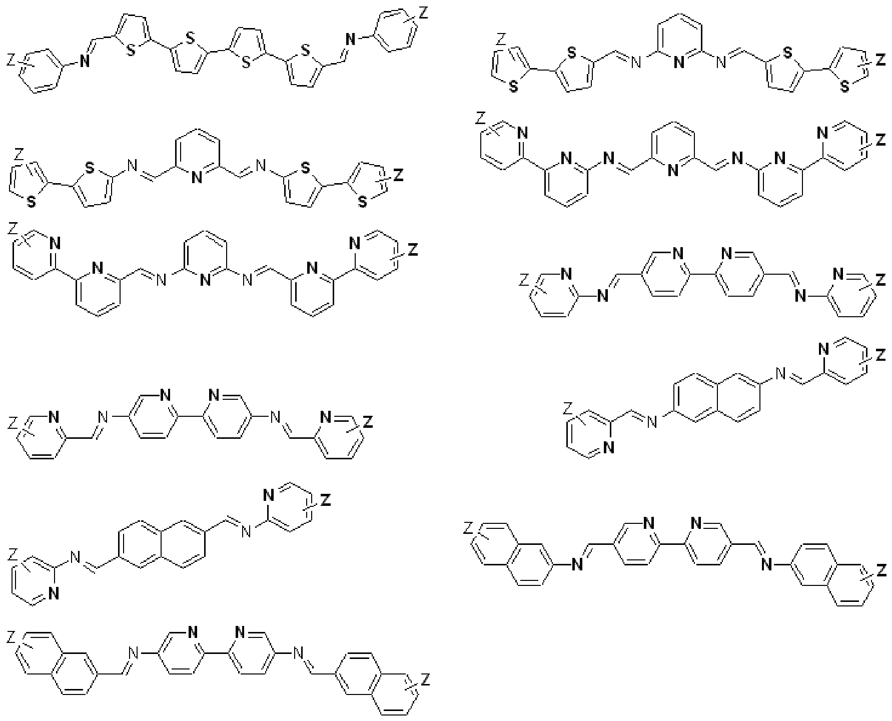 (wherein, Z represents an aldehyde group or an amino group).

9. The method for producing the polyazomethine according to Claim 7 or 8, wherein the hydrocarbon compound is at least one kind of compound selected from the group consisting of compounds represented by the following formulas: 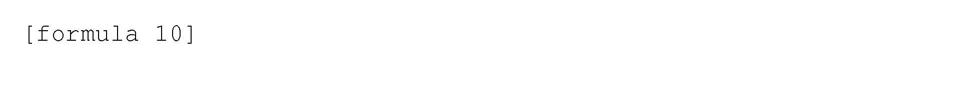 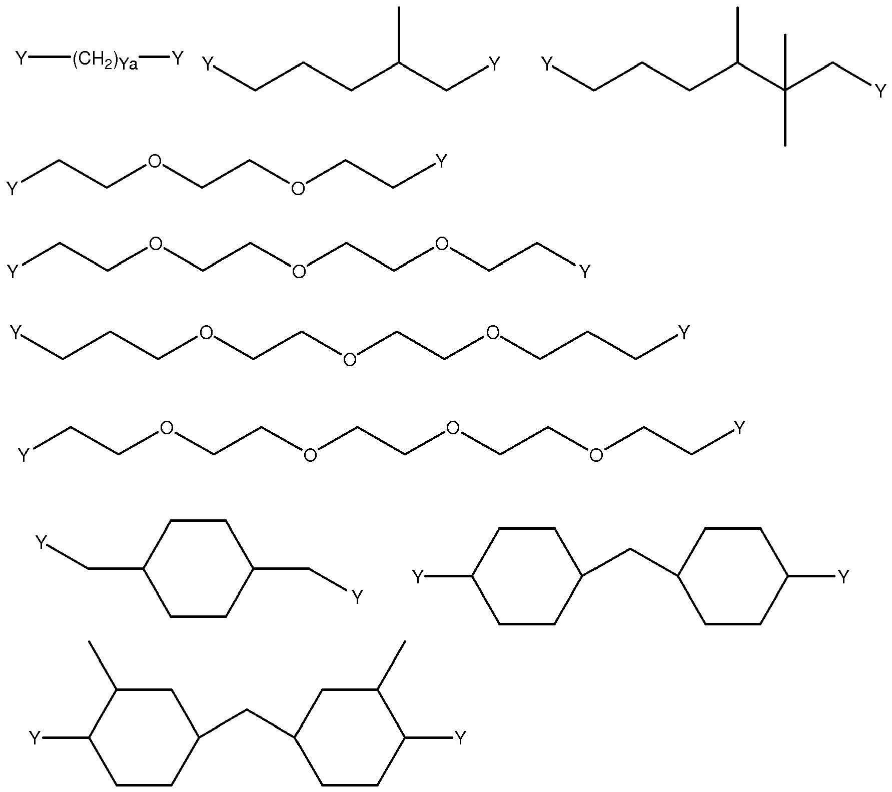 (wherein, Y represents an aldehyde group or an amino group, and Ya is an integer of 6 to 12).
